(19) Europäisches Patentamt
European Patent Office
Office européen des brevets

(11) EP 4 112 655 A1

(12) # EUROPEAN PATENT APPLICATION
published in accordance with Art. 153(4) EPC

(43) Date of publication:
**04.01.2023 Bulletin 2023/01**

(21) Application number: **21761065.8**

(22) Date of filing: **24.02.2021**

(51) International Patent Classification (IPC):
***C08F 14/18*** *(2006.01)* ***C08L 27/12*** *(2006.01)*
***H05B 33/10*** *(2006.01)* ***H01L 51/50*** *(2006.01)*

(52) Cooperative Patent Classification (CPC):
**C08F 14/18; C08L 27/12; H01L 51/50; H05B 33/10;**
Y02E 10/549; Y02P 70/50

(86) International application number:
**PCT/JP2021/006902**

(87) International publication number:
**WO 2021/172369 (02.09.2021 Gazette 2021/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **26.02.2020 JP 2020030460**

(71) Applicant: **AGC INC.**
**Chiyoda-ku,**
**Tokyo 1008405 (JP)**

(72) Inventors:
- **ABE Takefumi**
  **Tokyo 100-8405 (JP)**
- **TSURUOKA Kaori**
  **Tokyo 100-8405 (JP)**
- **SHIMOHIRA Tetsuji**
  **Tokyo 100-8405 (JP)**
- **TAKEI Saki**
  **Tokyo 100-8405 (JP)**
- **BEPPU Shotaro**
  **Tokyo 100-8405 (JP)**

(74) Representative: **Müller-Boré & Partner Patentanwälte PartG mbB**
**Friedenheimer Brücke 21**
**80639 München (DE)**

(54) **FLUORINE-CONTAINING POLYMER, FILM, FILM MANUFACTURING METHOD, AND ORGANIC OPTO-ELECTRONIC ELEMENT**

(57) A fluorinated polymer suitable for deposition is provided. A film containing such a fluorinated polymer as a material is provided. A method for producing a film, by which such a film can readily be produced, is provided. Further, an organic photoelectronic element having such a film in its structure is provided.

A fluorinated polymer which satisfies the following requirements (1) to (3):
(1) the melting point is 200°C or higher,
(2) the thermogravimetric loss rate when the temperature is increased at a temperature-increasing rate of 2°C/min under a pressure of $1\times10^{-3}$ Pa, substantially reaches 100% at 400°C or lower,
(3) when the temperature is increased at a temperature-increasing rate of 2°C/min under a pressure of $1\times10^{-3}$ Pa, the temperature width from a temperature at which the thermogravimetric loss rate is 10% to a temperature at which it is 90%, is within 100°C.

Fig. 1

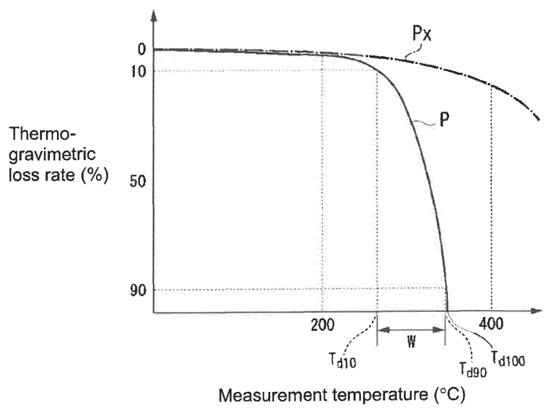


EP 4 112 655 A1

## Description

TECHNICAL FIELD

The present invention relates to a fluorinated polymer, a film, a method for producing a film, and an organic photoelectronic element.

BACKGROUND ART

Heretofore, as a self-light emitting element, an organic photoelectronic element (an organic electroluminescence element, hereinafter referred to as an organic EL element) has been known. An organic EL element has, as a basic structure, a structure having a pair of electrodes and between the electrodes, several types of layers such as a light emitting layer, an electron transport layer and a hole transport layer laminated.

As the material of the several types of the layers constituting the organic EL element, a fluororesin may sometimes be used. The fluororesin is used for various purposes, e.g. as a low refractive index material to lower the refractive index of a layer, and a buffer for an electrode.

For example, an organic EL element having an anode buffer layer made of a fluororesin has been known ( Patent Document 1). The organic EL element disclosed in Patent Document 1 has the anode buffer layer formed by depositing the fluororesin.

PRIOR ART DOCUMENTS

PATENT DOCUMENT

Patent Document 1: CN Patent No.100557852

DISCLOSURE OF INVENTION

TECHNICAL PROBLEM

Patent Document 1 discloses in Examples to deposit a fluororesin under reduced pressure in a vacuum chamber. In Examples in Patent Document 1, the pressure in the chamber of $8\times10^{-3}$ Pa when the deposition started increased to 1 to $3\times10^{-2}$ Pa when the deposition was completed. It is considered that the fluororesin used is thermally decomposed under the deposition conditions and the resulting low molecular weight decomposed products are vaporized to increase the pressure in the chamber.

If a fluororesin which is thermally decomposed during deposition is used as disclosed in Patent Document 1, it is estimated that desired deposition conditions will hardly be secured. Accordingly, the quality of organic EL elements, even if obtained, may not be stable, and improvement has been desired.

Under these circumstances, it is an object of the present invention to provide a fluorinated polymer suitable for deposition. Another object is to provide a film containing such a fluorinated polymer as a material. Another object is to provide a method for producing a film by which such a film can readily be produced. Still another object is to provide an organic photoelectronic element having such a film in its structure.

SOLUTION TO PROBLEM

To achieve the above objects, the present invention provides the following.

[1] A fluorinated polymer which satisfies the following requirements (1) to (3):

(1) the melting point is 200°C or higher,
(2) the thermogravimetric loss rate when the temperature is increased at a temperature-increasing rate of 2°C/min under a pressure of $1\times10^{-3}$ Pa, substantially reaches 100% at 400°C or lower,
(3) when the temperature is increased at a temperature-increasing rate of 2°C/min under a pressure of $1\times10^{-3}$ Pa, the temperature width from a temperature at which the thermogravimetric loss rate is 10% to a temperature at which it is 90%, is within 100°C.

[2] The fluorinated polymer according to [1], wherein the storage elastic modulus at 25°C is $1\times10^{7}$ Pa or higher, and a temperature at which the storage elastic modulus which changes when the temperature is decreased at a temperature-decreasing rate of 2°C/min becomes less than $1 \times 10^6$ Pa, is 120°C or higher.

[3] The fluorinated polymer according to [1] or [2], which has units derived from a fluoroolefin.

[4] The fluorinated polymer according to [3], which has at least units derived from tetrafluoroethylene.

[5] The fluorinated polymer according to [3] or [4], which has units derived from a perfluoroalkyl vinyl ether.

[6] The fluorinated polymer according to [5], wherein the perfluoroalkyl vinyl ether is perfluoropropyl vinyl ether.

[7] A film containing the fluorinated polymer as defined in any one of [1] to [6], and an organic semiconductor.

[8] The film according to [7], wherein the proportion of the fluorinated polymer to the total amount of the fluorinated polymer and the organic semiconductor is from 20 to 80 vol%.

[9] The film according to [7] or [8], which further contains a dopant.

[10] The film according to any one of [1] to [9], which is a co-deposited film of the fluorinated polymer and the organic semiconductor.

[11] A method for producing a film, which comprises a step of co-depositing the fluorinated polymer as defined in any one of [1] to [6], and an organic semiconductor.

[12] The method for producing a film according to [11], wherein in the co-deposition step, a dopant is further used.

[13] An organic photoelectronic element, comprising the film as defined in any one of [7] to [10].

[14] The organic photoelectronic element according to [13], which comprises

a substrate,
an anode provided on the substrate, a cathode facing the anode,
an active layer disposed between the anode and the cathode,
a hole transport layer disposed between the active layer and the anode, and a hole injection layer disposed between the hole transport layer and the anode,
wherein at least one of the hole transport layer and the hole injection layer is the above-described film.

[15] The organic photoelectronic element according to [13] or [14], which comprises

a substrate,
an anode provided on the substrate,
a cathode facing the anode,
an active layer disposed between the anode and the cathode,
an electron transport layer disposed between the active layer and the cathode, and
an electron injection layer disposed between the electron transport layer and the cathode,
wherein at least one of the electron transport layer and the electron injection layer is the above-described film.

## ADVANTAGEOUS EFFECTS OF INVENTION

According to the present invention, a fluorinated polymer suitable for deposition is provided. A film containing such a fluorinated polymer as a material is provided. A method for producing a film, by which such a film can readily be produced, is provided. Further, an organic photoelectronic element having such a film in its structure is provided.

## BRIEF DESCRIPTION OF DRAWINGS

Fig. 1 is a view schematically illustrating the requirements (2) and (3) for the fluorinated polymer.
Fig. 2 is a schematic cross sectional view illustrating a film according to a first embodiment.
Fig. 3 is a schematic view illustrating a step for producing a film 10.
Fig. 4 is a schematic view illustrating a step for producing a film 10.
Fig. 5 is a schematic view illustrating a step for producing a film 10.
Fig. 6 is a schematic cross sectional view illustrating an organic photoelectronic element (an organic EL element) 100 according to a second embodiment of the present invention.
Fig. 7 is a view illustrating an organic EL element 200 according to a third embodiment of the present invention.

## DESCRIPTION OF EMBODIMENTS

A "unit" constituting a polymer in this specification means a moiety present in the polymer to constitute the polymer, derived from one molecule of a monomer (that is a monomer unit). Hereinafter, a unit derived from each monomer will sometimes be represented as the monomer name followed by "unit".

In this specification, the "main chain" of a polymer means a carbon atom chain formed by addition polymerization of a monomer having a carbon-carbon unsaturated double bond, constituted by the carbon atoms which have constituted the carbon-carbon unsaturated double bond in the monomer.
In this specification, an "aliphatic ring" means not only a carbocyclic ring having a cyclic skeleton constituted solely of carbon atoms but also a heterocyclic ring having a cyclic skeleton containing an atom (hetero atom) other than carbon atoms. The hetero atom may, for example, be an oxygen atom, a nitrogen atom or a sulfur atom.

[First embodiment]

Now, the fluorinated polymer, the film, the method for producing a film according to a first embodiment of the present invention will be described with reference to Figs. 1 to 5. In the drawings, for visibility, the dimensions, the ratios, etc. of the constituting elements are properly changed.

(Fluorinated polymer)

The fluorinated polymer according to the present embodiment satisfies the following requirements (1) to (3).
Requirement (1): the melting point is 200°C or higher.
Requirement (2): the thermogravimetric loss rate when the temperature is increased at a temperature-increasing rate of 2°C/min under a pressure of $1\times10^{-3}$ Pa, substantially reaches 100% at 400°C or lower,
**[0019]** Requirement (3): when the temperature is increased at a temperature-increasing rate of 2°C/min under a pressure of $1\times10^{-3}$ Pa, the temperature width from a temperature at which the thermogravimetric loss rate is 10% to a temperature at which it is 90%, is within 100°C.
The fluorinated polymer which satisfies the above requirements (1) to (3) has physical properties suitable for deposition and is capable of suitably forming a deposited film.
Explanations will be made in order.

(Structure of fluorinated polymer)

The fluorinated polymer according to the present embodiment is not restricted with respect to its units so long as it is a polymer having high crystallinity and having a melting point within a desired range.
The fluorinated polymer is preferably a polymer having units derived from a fluoroolefin. More specifically, the fluorinated polymer preferably has at least units derived from tetrafluoroethylene (TFE) (that is TFE units).
The fluorinated polymer is commonly known to have high crystallinity when it contains TFE units or units derived from chlorotrifluoroethylene (CTFE) (that is CTFE units) with a high proportion. Accordingly, it is preferred that the fluorinated polymer according to the present embodiment also contains TFE units or CTFE units with a high proportion.
The proportion of the TFE units or the CTFE units to the entire fluorinated polymer is preferably 50 mol% or more, more preferably 70 mol% or more, further preferably 90 mol% or more. When the fluorinated polymer contains both the TFE units and the CTFE units, the sum of the proportion of the TFE units and the proportion of the CTFE units is preferably the above proportion or higher.
The upper limit of the proportion is 100 mol%.
The fluorinated polymer according to the present embodiment may be a homopolymer of TFE or CTFE or may be a copolymer of two or more monomers selected from the group consisting of TFE or CTFE and other monomers.
The above other monomer is not particularly limited so long as it is copolymerizable with TFE or CTFE. Such other monomer may be a hydrocarbon monomer or may be a fluorinated monomer.
The hydrocarbon monomer as other monomer may be a hydrocarbon monomer such as ethylene, propylene or styrene.
In a case where a hydrocarbon monomer is used as other monomer, the proportion of units derived from other monomer to all the units of the fluorinated polymer is preferably 50 mol% or lower, more preferably 30 mol% or lower, further preferably 10 mol% or lower.
The other monomer is preferably a fluorinated monomer, whereby the obtainable fluorinated polymer has a relatively low refractive index. The fluorinated monomer is preferably a perfluoro compound.
The fluorinated monomer as other monomer may be a monomer which forms units having an alicyclic structure in the main chain of the fluorinated polymer by polymerization, but is preferably a monomer other than such a monomer which brings an alicyclic structure in the main chain. The fluorinated polymer having no alicyclic structure in the main chain has high crystallinity as compared with a fluorinated polymer having an alicyclic structure in the main chain, and the melting point of such a fluorinated polymer will readily be adjusted to the desired range.
The monomer which forms units having an alicyclic structure in the main chain by polymerization may be the after-described perfluorocyclic monoene or cyclopolymerizable perfluorodiene.

The fluorinated monomer other than a perfluoro compound may, for example, be trifluoroethylene (TrFE), vinylidene fluoride (VdF), 1,2-difluoroethylene or 1-fluoroethylene.

The perfluoro compound as the fluorinated monomer may, for example, be the following perfluoroolefin, perfluoroalkyl vinyl ether, perfluorocyclic monoene or cyclopolymerizable diene.

Perfluoroolefin: hexafluoropropene (HFP), etc.

Perfluoroalkyl vinyl ether: perfluoromethyl viny ether (PMVE), perfluoroethyl vinyl ether (PEVE), perfluoropropyl vinyl ether (PPVE), etc.

Perfluorocyclic monoene: perfluoro(4-methoxy-1,3-dioxol), perfluoro(2,2-dimethyl-1,3-dioxole), perfluoro(4-methyl-2-methylene-1,3-dioxolane), etc.

Cyclopolymerizable perfluorodiene: perfluoro(3-butenyl vinyl ether), etc.

Among them, the fluorinated polymer preferably has perfluoroalkyl vinyl ether units. Particularly, the fluorinated polymer preferably has PPVE units.

When the content of the PPVE units in the fluorinated polymer changes, the melting point changes. Specifically, as the proportion of the PPVE units in the fluorinated polymer increases, the melting point of the fluorinated polymer tends to decrease.

The content of the PPVE units in the fluorinated polymer is preferably less than 14 mol%, more preferably 10 mol% or lower.

The upper limit of the content of the PPVE units in the fluorinated polymer is not particularly limited and is preferably more than 0 mol%, more preferably 1 mol% or more.

With respect to the content of the PPVE units in the fluorinated polymer, the upper limit and the lower limit may optionally be combined. For example, the content is preferably from 1 to 12 mol%.

The above-described monomer is polymerized usually by radical polymerization using a radical polymerization initiator. In such a case, the fluorinated polymer at the time of completion of the polymerization is considered to have, as a structure at the terminal of the molecular chain (main chain), a structure having fragments of the radical polymerization initiator used for the polymerization added. Further, in a case where a chain transfer agent is used for polymerization, the structure at the terminal of the molecular chain (main chain) may be a structure having fragments of the chain transfer agent added.

Of the fluorinated polymer, the above terminal structure may be converted to other structure. For example, by subjecting the fluorinated polymer at the time of completion of the polymerization to heat treatment at 300°C or higher, the structure at the terminal of the main chain becomes -C(=O)-F, and the fluorinated polymer becomes an acid fluoride.

By subjecting the acid fluoride to methanol treatment, the structure at the terminal of the main chain becomes a methyl ester group. The acid fluoride with high reactivity may be converted into a methyl ester group by simple methanol treatment. Thus, the stability of the obtainable fluorinated polymer is likely to be improved, such being favorable.

Further, by subjecting the acid fluoride to fluorination treatment, the structure at the terminal of the main chain becomes a trifluoromethyl group. As the fluorination treatment, for example, treatment method disclosed in JP-A-H11-152310, paragraph [0040] may be mentioned. The trifluoromethyl group has high heat resistance and is likely to improve heat resistance of the obtainable fluorinated polymer, and is thereby preferred.

The fluorinated polymer preferably has, as the structure at the terminal of the main chain, a methyl ester group or a trifluoromethyl group, whereby intermolecular interaction at the terminal of the main chain tends to be small, and deposition will readily be conducted.

The above-described structure at the terminal of the main chain can be confirmed by infrared spectroscopy.

(Requirement (1))

The fluorinated polymer according to the present embodiment preferably has crystallinity. By the fluorinated polymer having crystallinity, it is likely to have a melting point of 200°C or higher. The melting point of the fluorinated polymer according to the present embodiment is preferably 215°C or higher, more preferably 225°C or higher, further preferably 240°C or higher.

The upper limit of the melting point of the fluorinated polymer according to the present embodiment is not particularly limited and is preferably 350°C or lower, more preferably 320°C or lower, further preferably 300°C or lower.

The upper limit and the lower limit of the melting point of the fluorinated polymer may optionally be combined. For example, the melting point of the fluorinated polymer may be from 200 to 350°C, may be from 215 to 320°C, or may be from 225 to 300°C.

In the present embodiment, as the melting point, a value measured by a differential scanning calorimeter (for example, manufactured by NETZSCH, DSC 204 F1 Phoenix) is employed. 9 mg of the fluorinated polymer is put in a sample container, the heat capacity when the temperature is increased from -70°C to 350 at a rate of 10°C per minute is measured, and the melting point is determined from the obtained melting peak.

(Requirement (2))

In the present embodiment, as the thermogravimetric loss rate, a value measured by a vacuum differential thermobalance (manufactured by ADVANCE RIKO, Inc., VPE-9000) is employed. Specifically, 50 mg of the fluorinated polymer is put in a cell having an inner diameter of 7 mm, and the weight loss rate (%) of the fluorinated polymer when the temperature is increased from room temperature to 500°C at a rate of 2°C per minute in a degree of vacuum of $1\times10^{-3}$ Pa, to the initial weight (50 mg), is measured.

In the requirement (2), "substantially" means that in the above method of measuring the thermogravimetric loss rate, the thermogravimetric loss in a temperature range higher than 400°C is lower than the detection lower limit and the thermogravimetric loss can not be confirmed.

The fluorinated polymer according to the present embodiment may be considered to have a lower molecular weight (degree of polymerization) as the temperature which satisfies the requirement (2) is lower. If a fluorinated polymer which does not satisfy the requirement (2) is to be heated in a temperature range higher than 400°C so that the fluorinated polymer is deposited, the fluorinated polymer may be thermally decomposed. In such a case, products formed by thermal decomposition may increase the internal pressure of a vacuum chamber used for deposition. If the internal pressure of a vacuum chamber is increased, the deposition conditions tend to be unstable, and the quality of the deposited film may not be stable. Further, a partially thermally decomposed fluorinated polymer may be included into the deposited film, thus impairing the quality of the deposited film.

On the other hand, the fluorinated polymer which satisfies the requirement (2) can be suitably used for deposition by heating to a temperature lower than 400°C, as a material of deposition conducted in vacuum. Thus, it will not be thermally decomposed and can be used for deposition under stable deposition conditions.

The heat resistance of the fluorinated polymer may be evaluated as follows, focusing on the change of the internal pressure of the vacuum chamber.

[Method of evaluating chamber pressure change at the time of deposition]

0.1 g of the fluorinated polymer is put in a vacuum deposition apparatus, the pressure in the chamber is reduced to $10^{-4}$ Pa or lower, and the fluorinated polymer is deposited in a thickness of 200 nm at a deposition rate of 0.1 nm/sec. On that occasion, the pressure in the chamber is monitored, and the maximum value of the pressure at the time of deposition is measured.

A fluorinated polymer with a chamber pressure increase ratio determined in accordance with the following formula of 2 times or less can be suitably used for deposition.

Chamber pressure increase ratio at the time of deposition= maximum pressure during deposition/initial pressure before deposition

A fluorinated polymer with an increase ratio of more than 2 times is likely to be thermally decomposed and is judged inappropriate for use for deposition.

Further, if the fluorinated polymer undergoes thermal decomposition to such an extent that the chamber pressure increase ratio is higher than 10 times, the quality of the deposited film to be produced may be unstable due to products formed by thermal decomposition.

The fluorinated polymer according to the present embodiment is preferably such that when the temperature is increased at a temperature-increasing rate of 2°C/min under a pressure of $1\times10^{-3}$ Pa, the thermogravimetric loss rate substantially reaches 100% at 350°C or lower.

(Requirement (3))

When the temperature of the fluorinated polymer according to the present embodiment is increased at a temperature-increasing rate of 2°C/min under a pressure of $1\times10^{-3}$ Pa, the temperature width from a temperature at which the thermogravimetric loss rate is 10% to a temperature at which it is 90%, is within 100°C.

The fluorinated polymer according to the present embodiment is considered to have a narrower molecular weight distribution as the temperature width which satisfies the requirement (3) is narrower.

When a deposited film is to be produced by using a fluorinated polymer which does not satisfy the requirement (3), the difference between the molecular weight of the fluorinated polymer deposited at the initial stage of the deposition and the molecular weight of the fluorinated polymer deposited at the final stage of the deposition tends to be significant, whereby in a single deposited film, the molecular weight of the fluorinated polymer may change in the deposited film thickness direction, and the physical properties of the deposited film may not be stable.

Further, in a case where a deposited film is to be produced continuously under the same conditions, if a fluorinated polymer which does not satisfy the requirement (3) is used, deposited films produced may not be uniform in quality among lots.

Thus, if a fluorinated polymer which does not satisfies the requirement (3) is used, the deposition conditions may be unstable, and the quality of the deposited film may not be stable.

On the other hand, with the fluorinated polymer which satisfies the requirement (3), the difference between the molecular weight of the fluorinated polymer deposited at the initial stage of the deposition and the molecular weight of the fluorinated polymer deposited at the final stage of the deposition tends to be small, whereby the change of the molecular weight of the fluorinated polymer in the deposited film thickness direction tends to be small. Thus, the physical properties of the deposited film tend to be stable.

Further, in a case where a deposited film is to be produced continuously under the same conditions, non-uniformity of the deposited films produced in quality among lots can be suppressed.

Thus, by using the fluorinated polymer which satisfies the requirement (3), the quality of the deposited film tends to be stable.

The fluorinated polymer according to the present embodiment is preferably such that when the temperature is increased at a temperature-increasing rate of 2°C/min under a pressure of $1\times10^{-3}$ Pa, the temperature width from a temperature at which the thermogravimetric loss rate is 10% to a temperature at which it is 90%, is within 70°C.

Fig. 1 is a view schematically illustrating requirements (2) and (3), and is a graph illustrating the relation of the thermogravimetric loss rate to the measurement temperature. The horizontal axis of Fig. 1 indicates the measurement temperature (unit: °C), and the vertical axis indicates the thermogravimetric loss rate (unit: %). In Fig. 1, the behavior of the fluorinated polymer which satisfies the requirements (2) and (3) is indicated by the reference P, and the behavior of the fluorinated polymer which does not satisfy the requirements (2) and (3) is indicated by the reference Px.

In Fig. 1, the graph P indicating the behavior of the fluorinated polymer according to the present embodiment, reaches a thermogravimetric loss rate of 100% at a temperature ($T_{d100}$) lower than 400°C. Whereas the graph Px indicating the behavior of the fluorinated polymer which does not satisfy the requirements (2) and (3), does not reach a thermogravimetric loss rate of 100% at 400°C.

Further, in Fig. 1, the graph P indicating the behavior of the fluorinated polymer according to the present embodiment has a value W which is $T_{d90}$-$T_{d10}$ of 100°C or less.

It is found from Fig. 1 that the fluorinated polymer according to the present embodiment undergoes steep thermogravimetric loss between the temperature $T_{d10}$ and the temperature $T_{d90}$.

(Molecular weight fractionation)

The fluorinated polymer which satisfies the requirements (2) and (3) may be obtained by molecular weight fractionation of a polymer. In the following description, a polymer to be subjected to the molecular weight fractionation will sometimes be referred to as "raw material polymer".

As a method of molecular weight fractionation, for example, a method of fractionating a polymer by the molecular weight by sublimation purification or supercritical extraction to adjust the polymer to satisfy the requirements (2) and (3), may be mentioned.

(Sublimation purification)

Sublimation purification is a means such that an object to be purified (raw material polymer) is heated under reduced pressure to sublimate or evaporate a part or the whole of the object to be purified, and utilizing a precipitation temperature difference among compounds contained in the gaseous state object to be purified, the desired compound is isolated and recovered as a solid. Such sublimation purification may be conducted by using a sublimation purification apparatus having a charge portion in which the object to be purified is put, and a collecting portion which isolates the gaseous state object to be purified by the precipitation temperature and collects each fraction as a solid, and being capable of maintaining a high degree of vacuum.

The structure of the sublimation purification apparatus is not particularly limited, and for example, so-called Mill-type sublimation purification apparatus comprising a glass condenser tube, a flask-shaped glass container surrounding the condenser tube, and a vacuum exhaust device which depressurizes the interior of the glass container, may be used. Further, as the sublimation purification apparatus, a glass tube-type sublimation purification apparatus comprising a cylindrical glass sublimation tube, a heating device which contains the sublimation tube in its interior and heats the sublimation tube, and a high vacuum exhaust device which depressurizes the interior of the sublimation tube, may also be used.

Now, sublimation purification of a fluorinated polymer and a molecular weight fractionation method by sublimation purification will be described with reference to a glass tube-type sublimation purification apparatus as an example.

In sublimation purification of a fluorinated polymer, a raw material polymer is put in the charge portion of the sublimation tube, and the degree of vacuum in the sublimation tube is increased, for example, to a pressure of $1\times10^{-3}$ Pa or lower by the high vacuum exhaust device, and then the charge portion is heated by the heating device, whereby

the fluorinated polymer contained in the raw material polymer is sublimated or evaporated.

A region on the side closer to exhaust by the high vacuum exhaust device than the charge portion, in the sublimation tube, corresponds to a "collecting portion". The collecting portion is set to have a temperature lower than the heating temperature in the charge portion. The fluorinated polymer sublimated or evaporated from the raw material polymer in the charge portion is precipitated and solidified on the wall of the collecting portion, and is collected.

The collecting temperature in the collecting portion corresponds to a temperature at which the fluorinated polymer is sublimated from a gas to a solid (precipitation temperature) and corresponds to the molecular weight of the fluorinated polymer. By providing a plurality of collecting portions differing in the collecting temperature in the sublimation tube, the raw material polymer can be separated into fluorinated polymer fractions differing in the molecular weight.

For example, specifically, in a case where the charge portion is heated to A °C and the collecting portions are heated to B °C and C °C from the side closer to the charge portion (A>B>C), in the collecting portion set to B °C, a fluorinated polymer within a molecular weight range such that it is in a gaseous state at A °C and is in a solid state at B °C is collected.

Likewise, in the collecting portion set to C °C, a fluorinated polymer within a molecular weight range such that it is in a gaseous state at B °C and is in a solid state at C °C is collected. That is, in the collecting portion set to C °C, among fluorinated polymer fractions contained in the raw material polymer, a fluorinated polymer with a collecting temperature width B °C-C °C, which is in a gaseous state at B°C and which is in a solid state at C °C, is collected.

The above requirement (3) may be satisfied by controlling the collecting temperature width as described above and collecting the fluorinated polymer in a collecting portion with a collecting temperature width of 100°C for example. The collected fluorinated polymer is confirmed whether it satisfies the requirement (3) or not, and if not, the temperature conditions of the collecting portion should be controlled to narrow the collecting temperature width.

A fluorinated polymer collected in a lower set temperature region in the collecting portion, is a fluorinated polymer such that its thermogravimetric loss rate reaches 100% at a lower temperature under a pressure of $1\times10^{-3}$ Pa, that is, it is a fluorinated polymer with a lower molecular weight.

The collecting temperature width is preferably 100°C or lower, more preferably 70°C or lower, further preferably 40°C or lower. The smaller the collecting temperature width is, the smaller the variation of the deposition conditions tends to be, and the more a phase separated structure homogeneous in the film thickness direction is likely to be formed.

Fluorinated polymer fractions differing in the collecting temperature width, separated by the molecular weight, may be mixed so long as the requirements (2) and (3) are satisfied.

(Supercritical extraction)

Supercritical extraction is a technique to obtain an extract utilizing high solubility and diffusibility of a supercritical fluid. In supercritical extraction, for example, a fluorinated polymer having a relatively low molecular weight is dissolved in supercritical $CO_2$ used as the supercritical fluid, and an extract is obtained.

Further, by using a fluorinated solvent as an additive (entrainer) to the supercritical fluid, solubility of the fluorinated polymer in the supercritical fluid can be increased.

The fluorinated solvent used as the entrainer is not particularly limited. For example, a fluorinated solvent with a fluorophilicity parameter $P_F$ of 1 or more as determined by the following method is preferred.

(Fluorophilicity parameter $P_F$)

To a two-phase system of 3 g of toluene and 3 g of perfluoromethylcyclohexane, 30 μL of the fluorinated solvent is dropwise added and thoroughly mixed, and left at rest overnight. Then, the fluorinated solvent contained in the toluene and the fluorinated solvent contained in the perfluoromethylcyclohexane are measured by gas chromatography. A value determined in accordance with the following formula (A), wherein $M_P$ is the concentration (unit: mL/L) of the fluorinated solvent in the toluene, and $M_F$ is the concentration (unit: mL/L) of the fluorinated solvent in the perfluoromethylcyclohexane, is taken as the fluorophilicity parameter $P_F$.

$$P_F=M_F/M_P \quad (A)$$

As the fluorinated solvent used as the entrainer, for example, the following compounds may be mentioned.

1,1,1,2,2,3,3,4,4,5,5,6,6-tridecafluorohexane (AC-2000, manufactured by AGC Inc.) ($P_F$=12)
1,1,1,2,2,3,3,4,4,5,5,6,6-tridecafluorooctane (AC-6000, manufactured by AGC Inc.) ($P_F$=5.6)
CYTOP CT-SOLV100E (manufactured by AGC Inc.) ($P_F$=8.2)
CYTOP CT-SOLV180 (manufactured by AGC Inc.) ($P_F=\infty$)

HFE7300 (manufactured by 3M) ($P_F$=8.2)
1,1,1,2,2,3,4,5,5,5-decafluoropentane (Vertre XF, manufactured by Chemours) ($P_F$=3.7)
1H,1H,2H,2H-perfluorooctanol ($P_F$=1.1)
1,1,2,2-tetrafluoroethyl-2,2,2-trifluoroethyl ether (AE-3000, manufactured by AGC Inc.) ($P_F$=0.6)
HCFC-225ca/HCFC-225cb (45/55) ($P_F$=0.3)
Perfluorobenzene ($P_F$=0.3)
Hexafluoro-2-propanol ($P_F$=0.24)
1H,1H,7H-perfluoroheptanol ($P_F$=0.23)
1H,1H,5H-perfluoropentanol ($P_F$=0.1)

The extraction step may be conducted, for example, by using supercritical $CO_2$ under an extraction pressure of 7.4 MPa or higher at an extraction temperature of 31°C or higher.

The extraction pressure is preferably 30 MPa or higher, more preferably 50 MPa or higher, further preferably 70 MPa or higher. The upper limit of the extraction pressure is not particularly limited and is preferably 100 MPa or lower. The upper limit and the lower limit of the extraction pressure may optionally be combined.

The extraction temperature is preferably 40°C or higher, more preferably 80°C or higher. The extraction temperature is preferably 300°C or lower, more preferably 200°C or lower, further preferably 100°C or lower. The upper limit and the lower limit of the extraction temperature may optionally be combined.

Within the above range, the desired fluorinated polymer can efficiently be obtained by molecular weight fractionation.

(Other requirements)

The fluorinated polymer according to the present embodiment preferably satisfies the following requirements (4) and (5).

Requirement (4): the storage elastic modulus at 25°C is $1\times10^7$ Pa or higher.

Requirement (5): when the temperature of the fluorinated polymer is decreased at a temperature-decreasing rate of 2°C/min, the temperature at which the storage elastic modulus becomes less than $1\times10^6$ Pa, is 120°C or higher.

The fluorinated polymer which satisfies the requirements (4) and (5), has high heat resistance.

The fluorinated polymer which satisfies the requirements (4) and (5) is obtained, for example, by changing the content of PPVE units in the fluorinated polymer. As the content of PPVE units increases, the storage elastic modulus tends to decrease.

In the present embodiment, as the storage elastic modulus, a value measured by a dynamic viscoelasticity measuring device (for example, manufactured by Anton Paar, MCR502) and a heating furnace for a viscoelasticity measuring device (for example, manufactured by Anton Paar, CTD450) is employed. Specifically, a sample (the fluorinated polymer) is heated to the melting point or higher and then its temperature is decreased at constant temperature-decreasing mode at 2°C/min. Using the above measuring device, the storage elastic modulus (G') is measured with a distortion of 0.01% at a frequency of 1 Hz.

Fig. 2 is a schematic cross sectional view illustrating a film according to the present embodiment. A film 10 shown in Fig. 2 is a co-deposited film of an organic semiconductor and the fluorinated polymer and is formed on a substrate 50.

In the film 10, the organic semiconductor and the fluorinated polymer are phase-separated, and the film 10 has domains 51b of the organic semiconductor and domains 52b of the fluorinated polymer. The domains 51b and the domains 52b are continuous in the film thickness direction.

The size D of each domain 52b in the film 10 plane direction may, for example, be from about 10 nm to about 20 nm.

In the following description, the above phase separated structure of the film 10 will sometimes be referred to as nanodomain structure.

As described above, the fluorinated polymer used in the present embodiment has a melting point of 200°C or higher and has high crystallinity. Usually, when a material having high crystallinity is used to form a film, the resulting film has high heat resistance. On the other hand, the film formed by using a material having high crystallinity, tends to have a high haze and low transparency, since the crystallized portion scatters visible light. Accordingly, it has been difficult to apply a film formed by using a material having high crystallinity to e.g. a photoelectronic element which requires transparency.

However, the film 10 has a nanodomain structure which is sufficiently small relative to visible light. Even if a part of the fluorinated polymer contained in such a film 10 is crystallized, the crystallized portion is in such a size that it fits into the nanodomain structure.

Thus, the film 10 hardly scatters visible light and thereby has high transparency.

Further, the film 10 has, based on the high crystallinity of the fluorinated polymer, high heat resistance. Accordingly, the film 10 maintains the nanodomain structure even exposed to high temperature and can maintain high transparency.

The haze of the film 10 and the heat resistance may be measured by the following method.

[Preparation of haze measurement sample]

On a glass substrate, α-NPD and the fluorinated polymer are co-deposited to form a 100 nm co-deposited film to obtain a haze measurement sample. The total deposition rate of the two materials is adjusted to 0.2 nm/sec. The deposition rate is adjusted to achieve a desired volume ratio of α-NPD and the fluorinated polymer in the co-deposited film.

[Measurement of haze]

The haze is measured by using a haze meter (manufactured by Toyo Seiki Seisaku-sho, Ltd, Haze Guard K50-290).

The initial haze of the haze measurement sample is measured, then the sample is heated on a hot plate heated to 100°C for 1 hour. The sample is returned to room temperature, and the haze is measured again. Further, the sample is heated on a hot plate heated to 120°C for 1 hour, and the haze is measured in the same manner.

The obtained haze is evaluated based on the following standards.

○: less than 0.2,
△: 0.2 or more and less than 0.5
×: 0.5 or more

The proportion of the fluorinated polymer to the total amount of the fluorinated polymer and the organic semiconductor constituting the film 10 is equal to the volume of the domains 52b to the entire film 10. The proportion of the domains 52b to the entire film 10 is preferably form 20 to 80 vol%. When the proportion of the fluorinated polymer is 20 vol% or more, such a film has a sufficiently low refractive index as compared with a film of an organic semiconductor containing no fluorinated polymer. Further, when the proportion of the fluorinated polymer is 80 vol% or less, electrical conductivity of the film 10 can be sufficiently secured.

The refractive index of the film 10 may be measured by the following method using a sample prepared by the following method.

[Preparation of refractive index measurement sample]

On a silicon substrate, α-NPD and the fluorinated polymer are co-deposited to form a 100 nm co-deposited film to obtain a refractive index measurement sample. The total deposition rate of the two materials is 0.2 nm/sec. The deposition rate is adjusted to achieve a desired volume ratio of α-NPD and the fluorinated polymer in the co-deposited film.

[Measurement of refractive index]

Using a multi incident angle spectroscopic ellipsometer (manufactured by J.A. Woollam, M-2000U), measurement is conducted at intervals of the angle of incidence of 5 degrees within a range of from 45 to 75 degrees, with respect to the film on the silicon substrate. At each angle, Ψ and Δ which are ellipsometry parameters are measured at intervals of about 1.6 nm within a wavelength range of from 450 to 800 nm. From the measurement data, the dielectric function of the organic semiconductor is subjected to fitting analysis by Cauchy's equation, and the refractive index of the deposited film to light having a wavelength of 600 nm is obtained.

As the organic semiconductor, a known semiconductor may be used, and an appropriate material may be selected depending upon the function of a device comprising the film 10 according to the present embodiment.

For example, as the organic semiconductor, a hole injection material constituting a hole injection layer of an organic EL element, an electron injection material constituting an electron injection layer, a hole transport material constituting a hole transport layer, an electron transport material constating an electron transport layer, and a host material and a guest material constituting a light emitting layer, may be mentioned.

As the hole injection material, an aromatic amine derivative may suitably be exemplified. As specific examples, the following α-NPD, TAPC, PDA, TPD and m-MTDATA may be mentioned, but the material is not limited thereto.

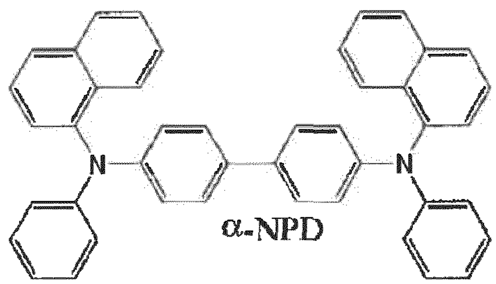

α-NPD

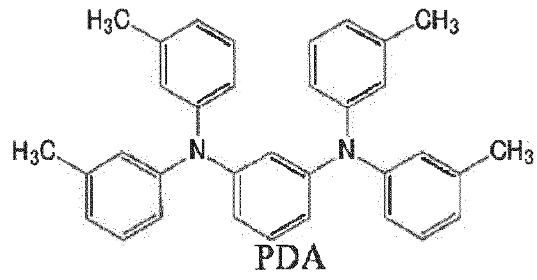

PDA

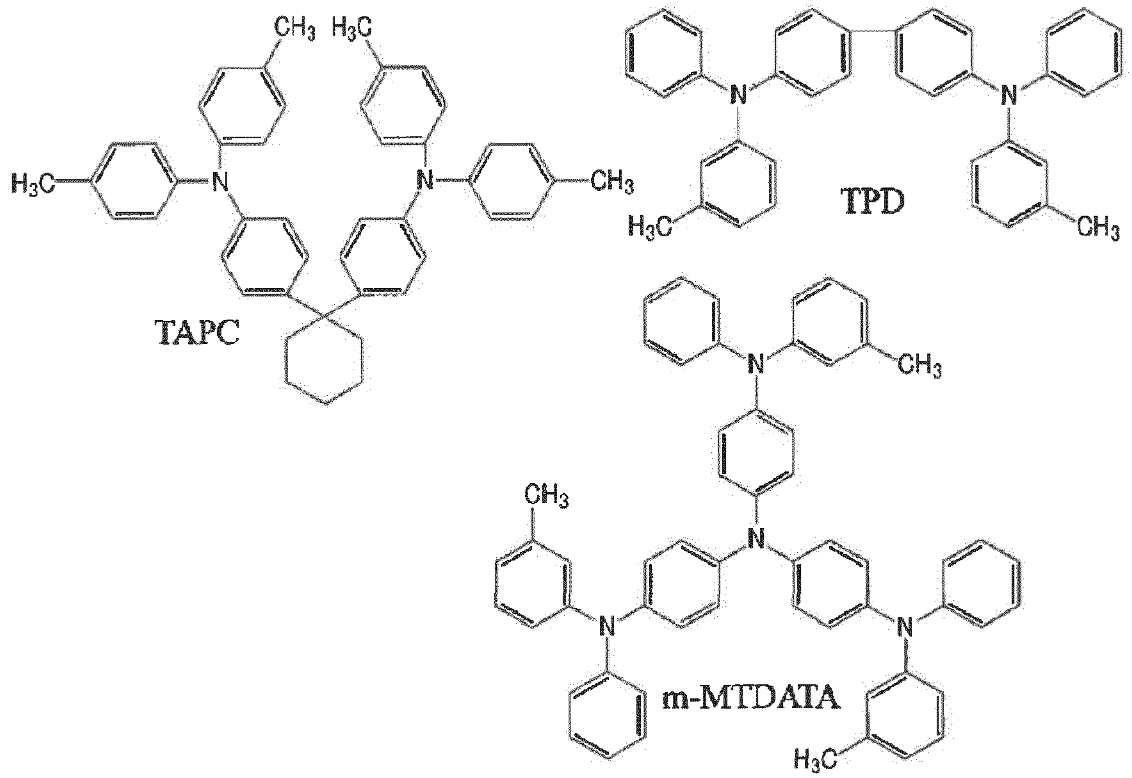

TAPC

TPD

m-MTDATA

As hole injection materials other than the above, for example, the following semiconductor material, organic metal complex material, arylamine material and polymer semiconductor material may be mentioned. Further, the following commercial products may be mentioned.

Semiconductor materials: metal oxides such as molybdenum oxide and tungsten oxide, and metal fluorides such as aluminum fluoride and magnesium fluoride.

Organic metal complex materials: copper phthalocyanine, etc.

Arylamine materials: N,N'-diphenyl-N,N'-bis-[4-(phenyl-m-tolyl-amino)-phenyl]-biphenyl-4,4'-diamine (DNTPD), N,N'-di(1-naphthyl)-N,N'-diphenyl benzidine (NPB), 4,4',4"-tris(N,N-diphenylamino)triphenylamine (TDATA), dipyrazino[2,3-f:2',3'-h]quinoxaline-2,3,6,7,10,11-hexacarbonitrile (HAT-CN), 9,9',9"-triphenyl-9H,9'H,9"H-3,3':6',3"-tercarbazole (Tris-PCz), 4,4',4"-tris(N,N-2-naphthylphenylamino)triphenylamine (2-TNATA), etc.

Polymer semiconductor materials: polyaniline/dodecylbenzenesulfonic acid (PANI/DBSA), poly(3,4-ethylenedioxythiophene)/poly(4-styrenesulfonate) (PEDOT/PSS), polyaniline camphorsulfonate (PANI/CSA), polyaniline/poly(4-styrenesulfonate) (PANI/PSS), etc.

Commercial products: N-(diphenyl-4-yl)-9,9-dimethyl-N-(4-(9-phenyl-9H-carbazoyl-3yl)phenyl)-9H-fluorene-2-amine (hereinafter referred to as "HT211"), HTM081 (manufactured by Merck), HTM163 (manufactured by Merck), HTM222 (manufactured by Merck), NHT-5 (manufactured by NoValed), NHT-18 (manufactured by NoValed), NHT-49 (manufactured by NoValed), NHT-51 (manufactured by NoValed), NDP-2 (manufactured by NoValed), NDP-9 (manufactured by NoValed), etc.

As the exemplified hole injection material, commercial products are available. Such a hole injection material may be a commercial product or may be a synthetic product. Further, the hole injection material may be used alone or in combination of two or more.

As the electron injection material, a known material may be used. As specific examples, inorganic compounds such as LiF, $Cs_2CO_3$ and CsF, and the following $Alq_3$, PBD, TAZ, BND, OXD-7 and 8-hydroxyquinolinolato-lithium (Liq) may be mentioned, but the electron injection material is not limited thereto. In addition, commercial products such as NDN-1 (manufactured by NoValed) and NDN-26 (manufactured by NoValed) may be used.

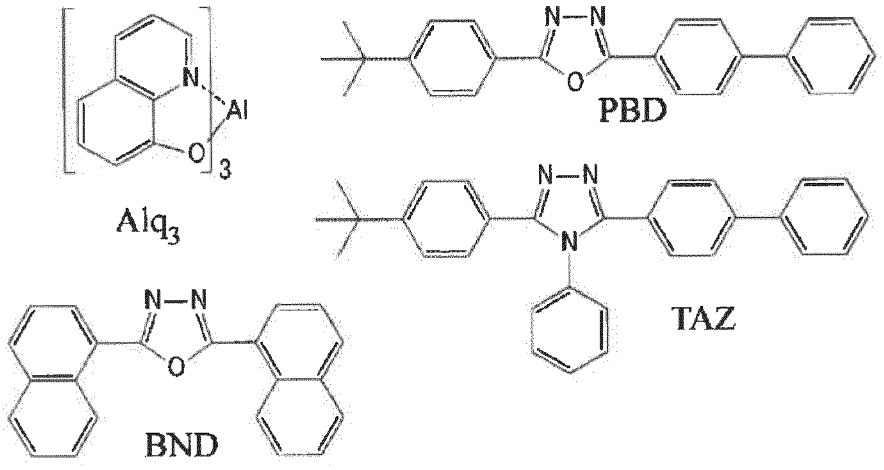
$Alq_3$ PBD TAZ BND

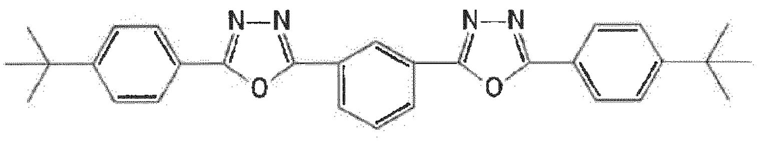
OXD-7

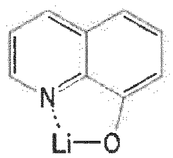
Liq

As the material (hole transport material) of the hole transport layer, for example, the above hole injection material may be mentioned, but the material is not limited thereto.

For example, an arylamine material other than the above mentioned as the hole injection material, such as 4,4',4"-tri(9-carbazoyl)triphenylamine (TCTA), 2,2',7,7'-tetrakis(N,N-diphenylamino)-2,7-diamino-9,9'-spirobifluorene (Spiro-TAD) or 2,2',7,7'-tetrakis(N,N-di-p-methoxyphenylamino)-9,9'-spirobifluorene (Spiro-MeOTAD), may be used as the hole transport material.

As hole transport materials other than the above mentioned as the hole injection material, a triazole derivative, an oxadiazole derivative, an imidazole derivative, a pyrazoline derivative, a pyrazolone derivative, a phenylenediamine derivative, an arylamine derivative, an amino-substituted chalcone derivative, an oxazole derivative, a styryl anthracene derivative, a fluorenone derivative, a hydrazone derivative, a stilbene derivative and a silazane derivative may, for example, be mentioned. Among them, it is preferred to use a porphyrin compound, an aromatic tertiary amine compound or a styryl amine compound, particularly an aromatic tertiary amine compound.

Such a hole transport material may be a commercial product or may be a synthetic product. Further, the hole transport material may be used alone or in combination of two or more.

As the material (electron transport material) of the electron transport layer, a known material may be used. For example, as the electron transport material, the above electron injection material may be mentioned, but the material is not limited thereto. As the electron transport material other than the above mentioned as the electron injection material, 2,2',2"-(1,3,5-benzinetriyl)-tris(1-phenyl-1-H-benzimidazole) (TPBi), 2,9-dimethyl-4,7-diphenyl-1,10-phenanthroline (BCP), 2-(4-tert-butylphenyl)-5-(4-biphenylyl)-1,3,4-oxadiazole (t-Bu-PBD), and a silole derivative having a silole ring may be mentioned.

Such an electron transport material may be a commercial product or may be a synthetic product. Further, the electron transport material may be used alone or in combination of two or more.

As a light emitting layer-forming material, a know material such as a fluorescent material, a thermally activated delayed fluorescence (TADF) material or a phosphorescent material may be employed.

For example, the light emitting layer-forming material may, for example, be a luminescent guest material such as (E)-2-(2-(4-(dimethylamino)styryl)-6-methyl-4H-pyran-4-ylidene)malononitrile (DCM), 4-(dicyanomethylene)-2-methyl-6-julolidyl-9-enyl-4H-pyran ($DCM_2$), Rubrene, Coumarin 6, $Ir(ppy)_3$, or $(ppy)_2Ir(acac)$, a phosphorescent host material such as 4,4'-bis(9H-carbazol-9-yl)biphenyl (CBP), 3,3'-di(9H-carbazol-9-yl)-1,1'-biphenyl (mCBP), a fluorescent host material such as ADN or Alq3, or a polymer material such as polyphenylenevinylene (PPV) or MEH-PPV, but is not limited thereto.

The light emitting layer-forming material may be used alone or in combination of two or more. The light emitting layer-forming material may properly be selected depending upon the desired emission wavelength.

The organic semiconductor as the film 10 forming material has a molecular weight of preferably from 300 to 1,000. The organic semiconductor has a molecular weight of preferably 400 or more. Further, the organic semiconductor has a molecular weight of preferably 900 or less.

When the organic semiconductor has a molecular weight of 300 or more, the organic semiconductor has a high glass transition point (Tg), and the organic semiconductor film will have improved heat resistance. When the organic semiconductor has a molecular weight of 1,000 or less, the organic semiconductor has a high vapor pressure, and deposition at the thermal decomposition temperature or lower becomes possible.

The upper limit and the lower limit of the molecular weight of the organic semiconductor may optionally be combined. That is, the molecular weight of the organic semiconductor may be from 300 to 900, may be from 400 to 1,000, or may be from 400 to 900.

The molecular weight of the organic semiconductor may be obtained by measurement by TOF-SIMS (Time-of-Flight Secondary Ion Mass Spectrometry).

The film 10 may further contain a dopant. The dopant may be a known one, and an appropriate material may be selected in accordance with the function of a device comprising the film 10 according to the present embodiment. By the film 10 containing a dopant, it has higher electrical conductivity.

For example, as a dopant used as the hole injection material, organic dopants such as TCNQ, $F_4$-TCNQ, PPDN, TCNNQ, $F_6$-TCNNQ, HAT-CN, HATNA, HATNA-$Cl_6$, HATNA-$F_6$, $C_{60}F_{36}$, $F_{16}$-CuPc, NDP-2 (manufactured by Novaled) and NDP-9 (manufactured by Novaled), and inorganic dopants such as $MoO_3$, $V_2O_5$, $WO_3$, $ReO_3$ and CuI may, for example, be mentioned.

As a dopant used as the electron injection material, 8-hydroxyquinolato-lithium (Liq), NDN-1 (manufactured by Novaled) and NDN-26(manufactured by Novaled) may, for example, be mentioned.

Figs. 3 to 5 are schematic views illustrating a step for producing the film 10.

First, as shown in Fig. 3, a substrate 50 on which the film 10 is to be formed is prepared. Such a substrate 50 is placed in a chamber 500 of a vacuum deposition apparatus, and from an organic semiconductor deposition source (crucible) 51 and a fluorinated polymer deposition source (crucible) 52 an organic semiconductor 51a and a fluorinated polymer 52a are supplied and co-deposited. In Fig. 3, the organic semiconductor and the fluorinated polymer are deposited from separate deposition sources, however, they may be deposited from a single deposition source.

As the organic semiconductor 51a and the fluorinated polymer 52a, the organic semiconductor and the fluorinated polymer constituting the film 10 may respectively be used.

At the time of co-deposition, the deposition conditions are set so that the proportion of the fluorinated polymer to the total amount of the fluorinated polymer and the organic semiconductor will be from 20 to 80 vol%, in a co-deposited film to be formed on the substrate 50.

The organic semiconductor 51a is preferably one which will not be decomposed by heating at the time of deposition. Not decomposed by heating at the time of deposition may be judged by obtaining the weight loss rate by the following method, with respect to the organic semiconductor used.

(Judgement method)

Measurement is conducted using a vacuum differential thermobalance (manufactured by ADVANCE RIKO, Inc., VPE-9000). 50 mg of the organic semiconductor is put in a cell having an inner diameter of 7 mm, and the weight loss rate (%) of the organic semiconductor when the temperature is increased to 500°C at a rate of 2°C per minute in a degree of vacuum of from $1\times10^{-3}$ Pa to $1\times10^{-4}$ Pa, is measured, and a temperature ($T_{d50}$) at which the weight loss rate becomes 50% is obtained.

Then, using a thermogravimetric differential thermal analyzer (manufactured by Hitachi High-Tech Science Corporation, STA7200), the weight loss rate of the organic semiconductor when the temperature is increased to 450°C at a rate of 10°C per minute in a nitrogen flow is measured, and the weight loss rate at $T_{d50}$ is obtained.

When the weight loss rate at $T_{d50}$ under normal pressure is 1% or less, it is judged that the weight loss at $T_{d50}$ under reduced pressure is caused by sublimation, not by thermal decomposition. It is judged that such an organic

semiconductor is not decomposed by heat at the time of deposition, that is it is suitable for deposition.

On the other hand, when the weight loss rate at $T_{d50}$ under normal pressure is more than 1%, it is judged that the weight loss at $T_{d50}$ under reduced pressure is caused by thermal decomposition. It is judged that such an organic semiconductor is decomposed by heat at the time of deposition and is thereby unsuitable for deposition.

As shown in Fig. 4, it is considered that when the organic semiconductor and the fluorinated polymer are co-deposited, the organic semiconductor and the fluorinated polymer are phase-separated on the substrate to form organic semiconductor domains 51b and fluorinated polymer domains 52b.

The sizes (diameters) of the fluorinated polymer domains 52b are considered to be within a certain numerical range with a small dispersion, due to the relation between the surface energy of the substrate 50 on which co-deposition is conducted and the surface energy of the fluorinated polymer. That is, it is considered that in a case where the fluorinated polymer to be used is likely to spread over the surface of the substrate 50, the domains 52b are likely to widely spread, and in a case where the fluorinated polymer is less likely to spread over the surface of the substrate 50, the domains 52b tend to have small diameters.

As shown in Fig. 5, it is considered that as the co-deposition continues, the organic semiconductor 51a sublimated from the deposition source 51 will be deposited on the organic semiconductor domains 51b, since such is energetically more stable than when deposited on the domains 52b Likewise, the fluorinated polymer 52a sublimated from the deposition source 52 will be deposited on the fluorinated polymer domains 52b since such is energetically more stable than when deposited on the domains 51b.

Accordingly, the organic semiconductor domains 51b continuous in the co-deposited film thickness direction and the fluorinated polymer domains 52b continuous in the co-deposited film thickness direction are formed. Further, when the co-deposited film is viewed from the substrate 50 normal direction, the diameters of the domains 52b will not significantly change in the co-deposited film thickness direction, and reflect the size of the domain 52 first deposited on the surface of the substrate 50.

By using the above-described fluorinated polymer, the fluorinated polymer constituting the domains 52b has a narrow molecular weight, and the difference in the physical properties between the initial stage and the terminal stage of the deposition tends to be small. Thus, the quality of the obtainable film 10 tends to be stable.

In such a manner, the film 10 is produced.

When the film 10 is heated, migration of the domains 52b is facilitated by heating, and the domains 52b close to each other may be united to collapse the nanodomain structure of the film 10. Whereas when the fluorinated polymer used satisfies the requirements (4) and (5), the domains 52b are less likely to be united, and the film 10 is likely to maintain the nanodomain structure.

The fluorinated polymer having the above-described constitution has high heat resistance and is suitable for deposition.

The film having the above-described constitution has a lowered refractive index, has high transparency and high heat resistance, and has stable quality.

Further, according to the method for producing a film of the above-described constitution, such a film can readily be produced.

In the present embodiment, the fluorinated polymer according to the present embodiment and the organic semiconductor are co-deposited to form the film 10, however, production of the film is not limited thereto. A film containing the fluorinated polymer according to the present embodiment and the organic semiconductor may be produced by a wet process such as coating.

[Second embodiment]

Fig. 6 is a schematic cross sectional view illustrating an organic photoelectronic element (organic EL element) 100 according to a second embodiment of the present invention. The organic EL element 100 has a structure having a substrate 110, an anode 111, a hole injection layer 112, a hole transport layer 113, a light emitting layer 114, an electron transport layer 115, an electron injection layer 116 and a cathode 117 laminated in this order. The organic EL element 100 according to the present embodiment employs top emission system by which light L generated in the light emitting layer 114 is taken to the outside via the cathode 117.

(Substrate)

The substrate 110 may have optical transparency or may not have optical transparency. The material forming the substrate 110 may be an inorganic material such as glass, quartz glass or silicon nitride, or an organic polymer (resin) such as a polyimide resin, an acrylic resin or a polycarbonate resin. Further, so long as the electrical insulating property of the surface is secured, the material forming the substrate 110 may be a metal material.

Further, the substrate 110 has various wires and drive elements electrically connected to the organic EL element,

which are not shown.

(Anode)

The anode 111 is formed on the substrate 110 and supplies holes to the hole transport layer 113. Further, the anode 111 has light reflectivity which reflects light emitted from the light emitting layer 114.

As the material forming the anode 111, an electrically conductive metal oxide such as ITO (indium tin oxide: indium doped tin oxide) or IZO (indium zinc oxide: indium doped zinc oxide) may be used. Further, in order to impart light reflectivity to the anode 111, on the substrate 110 side of the anode 111, a reflective film formed of a metal material is provided. That is, the anode 111 has a laminated structure of a layer formed of an electrically conductive metal oxide and a reflective film.

Further, as the material forming the anode 111, silver may also be used.

The thickness of the anode 111 is not particularly limited and is preferably from 30 to 300 nm. The thickness of the anode 111 is, for example, 100 nm.

(Hole injection layer)

The hole injection layer 112 is formed between the anode 111 and the hole transport layer 113. The hole injection layer 112 has a function to facilitate injection of holes from the anode 111 to the hole transport layer 113. The hole injection layer 112 is not necessarily formed.

The hole injection layer 112 may be formed by using the above-described hole injection material.

The thickness of the hole injection layer 112 is not particularly limited and is preferably from 1 to 100 nm. The thickness of the hole injection layer 112 is, for example, 5 nm.

(Hole transport layer)

The hole transport layer 113 is formed on the hole injection layer 112. The hole transport layer 113 has a function to favorably transport the holes injected from the anode 111 toward the light emitting layer 114.

The hole transport layer 113 may be formed by using the above-described hole transport material.

The hole transport layer 113 may be a single layer or may have a structure having a plurality of layers of the hole transport material laminated. In a case where the hole transport layer 113 is a laminate having a plurality of layers of the hole transport material laminated, the hole transport materials constituting the respective layers may be the same or different.

The hole transport layer 113 has an absorption coefficient in a wavelength region of from 450 to 800 nm of preferably 5,000 $cm^{-1}$ or less, more preferably 1,000 $cm^{-1}$ or less, and particularly preferably the hole transport layer 113 has no absorption band in the above wavelength region.

If the absorption coefficient of each layer constituting the hole transport layer 113 is more than 5,000 $cm^{-1}$, when light passes once through the hole transport layer having a thickness of 100 nm, 5% of the light will be absorbed to the total amount of the light before passing being 100%. Inside the organic EL element, by multiple interference of light, losses due to absorption of light at the time of passing through the hole transport layer 113 will accumulate. Therefore, the light absorption at the time of passing through the hole transport layer becomes a factor which will significantly lowers the light extraction efficiency. It is extremely important to use a hole transport layer having a sufficiently small light absorption, in order not to impair the light emission efficiency of the organic EL element. When the light emission efficiency of the organic EL element is not impaired, energy utilization efficiency becomes high, and the element lifetime becomes longer as a result of suppression of heat generation due to light absorption.

The thickness of the hole transport layer 113 is not particularly limited, and is preferably from 10 to 250 nm, more preferably from 20 to 150 nm.

(Light emitting layer)

The light emitting layer 114 is formed on the hole transport layer 113. In the light emitting layer 114, holes injected from the anode 111 and electrons injected from the cathode 117 are recombined to emit light by emitting photons. The emission wavelength at that time is determined depending on the material for forming the light emitting layer 114. The light emitting layer 114 corresponds to the "active layer" in the present invention.

The light emitting layer 114 may be formed by using the above material for forming the light emitting layer.

The material for forming the light emitting layer may be used alone or may be used in combination of two or more, and it is suitably selected depending on the desired light emission wavelength.

The thickness of the light emitting layer 114 is not particularly limited, and is preferably from 10 to 30 nm. The

thickness of the light emitting layer 114 is, for example, 15 nm.

(Electron transport layer)

The electron transport layer 115 is formed on the light emitting layer 114. The electron transport layer 115 has a function to satisfactorily transport electrons injected from the cathode 117 toward the light emitting layer 114.

The electron transport layer 115 may be formed by using the above described electron transport material.

The thickness of the electron transport layer 115 is not particularly limited, and is preferably from 30 to 80 nm. The thickness of the electron transport layer 115 is, for example, 60 nm.

(Electron injection layer)

The electron injection layer 116 is provided between the cathode 117 and the electron transport layer 115. The electron injection layer 116 has a function to facilitate injection of electrons from the cathode 117 into the electron transport layer 115. As the material for forming the electron injection layer 116, the above-described electron injection material may be used.

The electron injection layer 116 is not necessarily formed.

The thickness of the electron injection layer 116 is not particularly limited, and is preferably from 0.5 to 2 nm. The thickness of the electron injection layer 116 is, for example, 1 nm.

(Cathode)

The cathode 117 is formed on the electron injection layer 116. The cathode 117 has a function to inject electrons into the electron injection layer 116. As the material for forming the cathode 117, a known one may be used. For example, as the material for forming the cathode 117, a MgAg electrode or an Al electrode may be mentioned. On the surface of the cathode 117, a buffer layer such as LiF may be formed.

The cathode 117 is, as a whole, a semitransmissive film formed to be thin to such an extent to reflect part of light emitted from the light emitting layer 114, and transmit the rest.

The thickness of the cathode 117 is not particularly limited, and is preferably from 5 to 30 nm. The thickness of the cathode 117 is, for example, 5 nm.

(Microcavity structure)

In the organic EL element 100 of this embodiment, the anode 111 and the cathode 117 constitute a light resonator structure (microcavity) that resonates light between the anode 111 and the cathode 117. Between the anode 111 and the cathode 117, light generated in the light emitting layer 114 is repeatedly reflected, and light having a wavelength that matches the optical path length between the anode 111 and the cathode 117 is resonated and amplified. On the other hand, light having a wavelength that does not match the optical path length between the anode 111 and the cathode 117 is attenuated.

Here, the "optical path length" shall be calculated by using the desired wavelength of light emitted to the outside of the element and the refractive index of each layer at the desired wavelength of the light.

The optical path length between the anode 111 and the cathode 117 is, for example, set to be an integral multiple of the center wavelength of the light L generated by the light emitting layer 114. In that case, the light L emitted by the light emitting layer 114 will be emitted to the outside of the organic EL element 100 as amplified as it is closer to the center wavelength, or as attenuated as it departs from the center wavelength. In this way, the light L emitted from the organic EL element 100, becomes to be one, of which the half value width of the light emission spectrum is narrow, and the color purity is improved.

The microcavity structure utilizes resonance by fixed end reflections at both ends being the cathode and the anode. Therefore, in a case where "the optical path length from the light emission position to the anode, is an integral multiple of 1/4 of the desired wavelength $\lambda$ of the light emitted to the outside of the element" and "the optical path length from the light emission position to the cathode, is an integral multiple of 1/4 of the desired wavelength A of the light emitted to the outside of the element", it is possible to form the desired microcavity structure.

In the organic EL element 100 according to the present embodiment, any one or more of the above layers contain the above-described fluorinated polymer.

In the organic EL element 100 according to the present embodiment, it is preferred that at least one of the hole injection layer 112 and the hole transport layer 113 contains the above-described fluorinated polymer. In a case where the hole transport layer 113 is a laminated of layers of the hole transport material, at least one among the layers contains the above-described fluorinated polymer.

Further, in the organic EL element 100 according to the present embodiment, it is preferred that at least one of the electron transport layer 115 and the electron injection layer 116 contains the above-described fluorinated polymer. In a case where the electron transport layer 115 is a laminate of layers of the electron transport material, at least one among the layers contains the above-described fluorinated polymer.

Further, in the organic EL element 100 according to the present embodiment, it is preferred that at least one of the hole injection layer 112 and the hole transport layer 113, and at least one of the electron transport layer 115 and the electron injection layer 116, contain the above-described fluorinated polymer.

The layers containing the above-described fluorinated polymer, have a lower refractive index than such layers not containing the above-described fluorinated polymer. Accordingly, the organic EL element 100 according to the present embodiment has improved light extraction efficiency and has improved external quantum efficiency. Thus, the organic EL element 100 according to the present embodiment is capable of providing emission amount comparable to one by a conventional organic EL element not containing the above-described fluorinated polymer, with less input power.

Further, the layers containing the above-described fluorinated polymer have high heat resistance. Accordingly, the organic EL element 100 according to the present embodiment is a highly reliable organic EL element 100.

The heat resistance of the organic EL element 100 may be evaluated by the following method.

<Heat resistance evaluation 1>

[Preparation of electrical conductivity evaluation element 1]

A glass substrate having ITO (indium tin oxide) formed in a 2 mm-width strip is used.

The substate is subjected to ultrasonic cleaning in neutral detergent, acetone and isopropanol, cleaned in boiling isopropanol, and subjected to ozone treatment to remove attachment on the surface of the ITO film.

The cleaned substrate is put in a vacuum deposition apparatus, the pressure is reduced to $10^{-4}$ Pa or lower, and molybdenum trioxide is deposited on the substrate. The deposition rate is 0.1 nm/sec, and a 5 nm-thick layer is formed to prepare a hole injection layer.

Then, on the hole injection layer, α-NPD and the fluorinated polymer are co-deposited. The total deposition rate of the two materials is 0.2 nm/sec, and a 100 nm-thick layer is formed to prepare a charge transport layer. The deposition rate is adjusted to achieve a desired volume ratio of α-NPD and the fluorinated polymer in the charge transport layer.

Then, on the charge transport layer, aluminum is deposited in a 2 mm-width strip. The strip aluminum film is formed to be orthogonal to the ITO film in a field viewed from the direction perpendicular to the substrate. In such a manner, electrical conductivity evaluation element 1 having an element area of 4 $mm^2$ (=ITO film 2 mm × aluminum film 2 mm) is obtained.

[Evaluation of heat resistance of element 1]

Using a source meter (manufactured by Agilent Technologies, Inc., B1500A), a voltage is applied to the element 1 taking ITO as the anode and aluminum as the cathode while changing the voltage, a current flowing in the element is measured at each voltage, and the current density (J) (unit: $mA/cm^2$) to the electrical field (E) (unit: MV/cm) is obtained.

The electric field (E) is a value obtained by dividing the volage by a thickness of the charge transport layer of 100 nm, and the current density (J) is a value obtained by dividing the current by an area of the element of 4 $mm^2$.

Then, in $N_2$ atmosphere, the element 1 is heated on a hot plate at 80°C for 60 minutes. The element 1 is returned to room temperature, and the current flowing in the element is measured again, and the current density (J) (unit: $mA/cm^2$) to the electrical field (E) (unit: MV/cm) is obtained.

Then, in $N_2$ atmosphere, the element 1 is heated on a hot plate at 90°C for 60 minutes. The element 1 is returned to room temperature, and the current flowing in the element is measured again, and the current density (J) (unit: $mA/cm^2$) to the electrical field (E) (unit: MV/cm) is obtained.

From the obtained results, the heat resistance of the element 1 is evaluated based on the following standards.

×: current density at 0.4 MV/cm is less than 90% of the initial value after heating to 80°C
△: current density at 0.4 MV/cm is less than 90% of the initial value after heating to 90°C
○: current density at 0.4 MV/cm is 90% or more of the initial value after heating to 90°C

<Heat resistance evaluation 2>

[Preparation of electrical conductivity evaluation element 2]

Electrical conductivity evaluation element 2 is prepared in the same manner as in [Preparation of electrical conductivity evaluation element 1] except that HAT-CN is used instead of molybdenum trioxide, and HT211 is used instead of α-NPD.

[Evaluation of heat resistance of element 2]

In the same manner as in [Evaluation of heat resistance of element 1] except that the heating temperatures are 100°C, 110°C, 120°C and 130°C, and the heating times are respectively 15 minutes, the current density (J) (unit: $mA/cm^2$) to the electric field (E) (unit: MV/cm) is obtained.

From the obtained results, the heat resistance of the element 2 is evaluated based on the following standards.

×: current density at 0.4 MV/cm is less than 90% of the initial value after heating to 100°C
△: current density at 0.4 MV/cm is less than 90% of the initial value after heating to 110°C
○: current density at 0.4 MV/cm is less than 90% of the initial value after heating to 120°C
○○: current density at 0.4 MV/cm is less than 90% of the initial value after heating to 130°C
○○○: current density at 0.4 MV/cm is 90% or more of the initial value after heating to 130°C

Further, the above-described fluorinated polymer can be introduced to each layer in the form of a co-deposited film with the organic semiconductor constituting each layer. Specifically, for example, in a case where the above-described fluorinated polymer is to be contained both in the hole injection layer 112 and in the hole transport layer 113, the hole injection material and the fluorinated polymer are co-deposited to form a co-deposited film (first film) and then the hole transport material and the fluorinated polymer are co-deposited to form a co-deposited film (second film).

The organic EL element 100 of the above constitution, in which at least one of the hole injection layer 112 and the hole transport layer 113 contains the above-described fluorinated polymer, constitutes an organic EL element having improved external quantum efficiency with low power consumption.

[Third embodiment]

Fig. 7 is a view illustrating an organic EL element 200 according to a third embodiment of the present invention, and corresponds to Fig. 6.

The organic EL element 200 has a structure having a substrate 210, an anode 211, a hole injection layer 112, a hole transport layer 113, a light emitting layer 114, an electron transport layer 115, an electron injection layer 116 and a cathode 217 laminated in this order. The organic EL element 200 according to the present embodiment employs bottom emission system in which light L generated in the light emitting layer 114 is taken to the outside via the anode 211 and the substrate 210.

The substrate 210 has optical transparency. The material forming the substrate 210 may be an inorganic material such as glass, quartz glass or silicon nitride, or an organic polymer (resin) such as a polyimide resin, an acrylic resin or a polycarbonate resin. Further, a laminate of the above material or a composite material having the above materials mixed may also be used so long as it has light transparency.

The anode 211 is formed on the substrate 210 and supplies holes to the hole transport layer 113. As a material forming the anode 211, an electrically conductive metal oxide having light transparency such as ITO or IZO may be used.

The cathode 217 is formed on the electron injection layer 116. The cathode 217 has a function to inject electrons to the electron injection layer 116. Further, the cathode 217 has a function to reflect light L which is isotropically emitted in the light emitting layer 114 and direct the light L toward the anode 211. As a material forming the cathode 217, MgAg, Ag, Al or the like may be used. On the surface of the cathode 217, a buffer layer of e.g. LiF may be formed.

The thickness of the cathode 217 is not particularly limited and is preferably from 30 to 300 nm. The thickness of the cathode 217 is for example 100 nm.

In the organic EL element 200 of such a constitution also, in the same manner as the organic EL element 100 according to the second embodiment, any one or more of the layers preferably contain the above-described fluorinated polymer. More particularly, the organic EL element 200 is preferably such that at least one of the hole injection layer 112 and the hole transport layer 113 contains the above-described fluorinated polymer.

Further, the organic EL element 200 is preferably such that at least one of the electron transport layer 115 and the electron injection layer 116 contains the above-described fluorinated polymer.

Further, the organic EL element 200 is preferably such that at least one of the hole injection layer 112 and the

hole transport layer 113, and at least one of the electron transport layer 115 and the electron injection layer 116, contain the above-described fluorinated polymer.

Accordingly, the organic EL element 200 has improved light extraction efficiency as compared with a conventional organic EL element not containing the fluorinated polymer.

The organic EL element 200 of such a constitution also, in which each layer contains the above-described fluorinated polymer, constitutes an organic EL element having improved external quantum efficiency with less power consumption.

Further, the layer containing the above-described fluorinated polymer has high heat resistance. Accordingly, the organic EL element 200 according to the present embodiment constitutes a highly reliable organic EL element 200.

The heat resistance of the organic EL element 200 may be evaluated in the same manner as the above-described heat resistance of the organic EL element 100.

The organic EL element 100 or the organic EL element 200 may have other functional layer between the layers. For example, it may have a hole blocking layer or an electron blocking layer between the light emitting layer and the charge transport layer, or may have an adjusting layer to form the above-described microcavity structure.

Further, in the organic EL element 100 or the organic EL element 200, a wavelength conversion layer containing quantum dots may be disposed in the light emission direction. By the element having such a wavelength conversion layer, the organic EL element will be such that color purity of outgoing light is improved.

In the organic EL element 100 or the organic EL element 200, as a material for forming the light emitting layer 114, quantum dots may be used.

The quantum dots mean nano-scale semiconductor crystals having specific optical properties which comply with quantum mechanics. The quantum dots are usually monocrystalline particles having a diameter of from 2 to 10 nm. Since the band gap of the quantum dots changes depending upon the crystal size (=particle size), the band gap can be controlled by adjusting the particle size, and the desired emission wavelength will be obtained.

As the quantum dots, colloidal quantum dots dispersible in a solution may also be used. Such colloidal quantum dots may be formed by a conventional wet coating technology.

The type of the quantum dots is not particularly limited, and perovskite quantum dots, carbon quantum dots, alloy quantum dots, core/shell quantum dots, and core quantum dots may be used.

The above embodiments are described with reference to the organic EL element as the organic photoelectronic element, however, the organic photoelectronic element to which the film containing the fluorinated polymer of the present invention is applicable is not limited to the organic EL element.

The organic photoelectronic element of the present invention may, for example, be an organic semiconductor laser. The organic semiconductor laser may be one having a known constitution. By employing, for any film comprising an organic semiconductor constituting the organic semiconductor laser, a film containing the above-described fluorinated polymer, the organic semiconductor laser has improved external quantum efficiency.

Further, the organic photoelectronic element of the present invention may, for example, be a light-receiving element such as an optical sensor or a solar cell. As the optical sensor and the solar cell, one having a known constitution may be employed.

By employing, for any film comprising an organic semiconductor constituting an optical sensor or a solar cell, a film containing the above-described fluorinated polymer, the optical sensor has improved detection performance, or the solar cell has improved power generation efficiency.

The preferred embodiments of the present invention are described above with reference to drawings. However, the present invention is by no means restricted to such examples. Various forms, combinations, etc. of the respective constituents indicated above are merely examples, and various changes are possible in accordance with requirements in design, etc., within the scope of the present invention.

## EXAMPLES

Now, the present invention will be described in further detail with reference to Examples. However, it should be understood that the present invention is by no means restricted to such specific Examples.

### <Evaluation methods>

In the present embodiment, evaluation was made by the following methods.

### [Measurement of thermogravimetric loss rate of fluorinated polymer in vacuum]

Measurement was conducted by using a vacuum differential thermobalance (manufactured by ADVANCE RIKO, Inc.:VPE-9000). 50 mg of the fluorinated polymer was put in a cell having an inner diameter of 7 mm, and the

weight loss rate (%) of the fluorinated polymer when the temperature was increased from room temperature to 500°C at a rate of 2°C per minute in a degree of vacuum of $1\times10^{-3}$ Pa, to the initial weight (50 mg), was measured.

A temperature ($T_{d100}$) at which the weight loss rate became 100%, a temperature ($T_{d10}$) at which the weight loss rate became 10%, and a temperature ($T_{d90}$) at which the weight loss rate became 90%, were obtained.

[Measurement of melting point]

Measurement was conducted by using a differential scanning calorimeter (manufactured by NETZSCH, DSC 204 F1 Phoenix). 9 mg of the fluorinated polymer was put in a sample container, the heat capacity when the temperature was increased from -70°C to 350 at a rate of 10°C per minute was measured, and the melting point was determined from the obtained melting peak.

[Measurement of storage elastic modulus]

In the present embodiment, as the storage elastic modulus, a value measured by a dynamic viscoelasticity measuring device (manufactured by Anton Paar, MCR502) and a heating furnace for a viscoelasticity measuring device (manufactured by Anton Paar, CTD450) was employed.

Specifically, a sample (fluorinated polymer) was heated to the melting point or higher and then its temperature was decreased at a constant temperature-decreasing mode at 2°C/min. Using the above measuring device, the storage elastic modulus (G') was measured with a distortion of 0.01% at a frequency of 1 Hz, and G' at 25°C and a temperature at which G' become less than $1\times10^6$ Pa were obtained.

<Synthesis of fluorinated polymer>

The fluorinated polymer used for evaluation was synthesized as follows.

[Synthesis Example 1]

A jacketed polymerization vessel (made of stainless steel) having an internal capacity of 1.351 L was deaerated, and into the polymerization vessel, 701 g of 1,1,2,2-tetrafluoroethyl-2,2,2-trifluoroethyl ether (AE-3000, manufactured by AGC Inc.), 57 g of perfluoropropyl vinyl ether (PPVE), 108 g of tetrafluoroethylene (TFE) and 35.7 g of methanol weighed were put.

While the temperature of the polymerization vessel was kept at 60°C, 18.9 mL of a 0.53 mass% solution (solvent: AE-3000) of t-butyl peroxypivalate (PBPV) was charged to initiate polymerization.

During the polymerization, since the polymerization pressure decreases accompanying the progress of the polymerization, TFE was continuously introduced into the polymerization vessel so that the polymerization pressure would be substantially constant. The polymerization pressure was kept under $1.04\pm0.04$ MPaG (gauge pressure).

The "gauge pressure" is a relative pressure based on the atmospheric pressure being 0 MPaG, and indicates a difference with the absolute pressure taking the pressure in vacuum as 0.

The polymerization was terminated at a point when the amount of TFE introduced reached 121 g to obtain a fluorinated polymer. The composition of the obtained polymer was PPVE units:TFE units=2:98 (mol%).

Then, the obtained polymer was heated in an oven at 330°C, dipped in methanol and heated in an oven at 75°C for 40 hours to replace the terminal group with a methyl ester group to obtain fluorinated polymer A.

44 g of the obtained fluorinated polymer A was put in a raw material charge portion of a glass tube type sublimation purification apparatus, and the pressure in the interior of collecting portions was reduced to $3.0\times10^{-3}$ Pa. The raw material charge portion was gradually heated to 330°C to sublimate the fluorinated polymer A. In the sublimation purification apparatus, the collecting portions, from the side closer to the charge portion, were heated at set temperatures of 310°C, 280°C and 250°C.

Among such collecting portions, substances precipitated in the collecting portion at the set temperature of 280°C were recovered and purified to obtain 4 g of purified fluorinated polymer A1.

[Synthesis Example 2]

A fluorinated polymer was obtained in the same manner as in Synthesis Example 1 except that 649 g of AE-3000, 152 g of PPVE, 109 g of TFE, 15.5 g of methanol and 18.9 L of a 0.79 mass% solution (solvent: AE-3000) of PBPV were used.

The composition of the obtained fluorinated polymer was PPVE units:TFE units=4:96 (mol%).

Then, under the same conditions as in Synthesis Example 1, the terminal group of the fluorinated polymer was

replaced with a methyl ester group to obtain fluorinated polymer B.

In the same manner as in Synthesis Example 1 except that 20 g of the fluorinated polymer B was used, the fluorinated polymer B was sublimated. Substances precipitated in the collecting portion at a set temperature of 250°C were recovered and purified to obtain 2 g of purified fluorinated polymer B1.

Further, 20 g of the obtained fluorinated polymer B was put in a pressure container of a supercritical extraction apparatus and subjected to supercritical extraction by carbon dioxide.

Extraction was conducted under conditions (condition 1) at an extraction temperature of 40°C under an extraction pressure of 30 MPa at a carbon dioxide flow rate of 30 ml/min to obtain 0.2 g of an extract, and then extraction was conducted under conditions (condition 2) at an extraction temperature of 80°C under an extraction pressure of 60 MPa using as the entrainer AC-2000 (manufactured by AGC Inc.) at a proportion of 10 vol% relative to carbon dioxide to obtain 1.4 g of an extract.

The extract obtained under the condition 2 was taken as fluorinated polymer B2.

[Synthesis Example 3]

The fluorinated polymer synthesized in the same manner as in Synthesis Example 2 was heated in an oven at 330°C and treated by the method disclosed in JP-A-H11-152310, paragraph [0040] to replace the terminal group of the fluorinated polymer with - $CF_3$ group by fluorine gas to obtain fluorinated polymer C.

In the same manner as in Synthesis Example 1 except that the raw material charge portion was gradually heated to 360°C, the fluorinated polymer C was sublimated. Substances precipitated in the collecting portions at set temperatures of 250°C and 280°C were recovered to obtain 6 g of purified fluorinated polymer C1.

[Synthesis Example 4]

Into a stainless steel autoclave having an internal capacity of 1,006 mL, 57.9 g of PPVE, 767 g of AC2000 (manufactured by AGC Inc.), 4.13 g of methanol and 1.24 g of azobisisobutyronitrile (AIBN) were put, and the autoclave was freeze-deaerated with liquid nitrogen.

The temperature of the autoclave was increased to 70°C, and 48.4 g of TFE was introduced into the autoclave to initiate polymerization reaction. Since the pressure in the autoclave decreased as the polymerization proceeded, TFE was continuously supplied to conduct polymerization while the temperature and the pressure in the autoclave were kept constant. 5 hours after initiation of the polymerization, the autoclave was cooled to terminate the polymerization reaction, and the gas in the system was discharged to obtain a reaction solution.

800 g of methanol was added to the reaction solution and mixed to precipitate the polymer dissolved in the reaction solution, followed by phase separation, and the lower layer in which the polymer was dispersed was recovered. The obtained polymer dispersion was warm air-dried at 80°C for 16 hours and then vacuum dried at 100°C for 16 hours to obtain 19 g of fluorinated polymer.

The composition of the obtained fluorinated polymer was PPVE units:TFE units=6:94 (mol%).

Then, in the same manner as in Synthesis Example 1, the terminal group of the fluorinated polymer was replaced with a methyl ester group to obtain fluorinated polymer D.

In the same manner as in Synthesis Example 1, the fluorinated polymer D was sublimated. Substances precipitated in the collection portions at set temperatures of 250°C and 280°C were recovered to obtain 5 g of purified fluorinated polymer D1.

[Synthesis Example 5]

In the same manner as in Synthesis Example 4 except that 69.4 g of PPVE, 4.18 g of methanol and 1.26 g of AIBN were used, fluorinated polymer was obtained.

The composition of the obtained fluorinated polymer was PPVE units:TFE units=8:92 (mol%).

Then, under the same conditions as in Synthesis Example 3, the terminal group of the fluorinated polymer was replaced with a $-CF_3$ group to obtain fluorinated polymer E.

In the same manner as in Synthesis Example 2, the fluorinated polymer E was sublimated to obtain 4 g of purified fluorinated polymer E1.

[Synthesis Example 6]

In the same manner as in Synthesis Example 4 except that 78.9 g of PPVE, 4.23 g of methanol and 1.27 g of AIBN were used to obtain fluorinated polymer.

The composition of the obtained fluorinated polymer was PPVE units:TFE units=9:91 (mol%).

Then, In the same manner as in Synthesis Example 1, the terminal group of the fluorinated polymer was replaced with a methyl ester group to obtain fluorinated polymer F.
In the same manner as in Synthesis Example 1, the fluorinated polymer F was sublimated to obtain 4 g purified fluorinated polymer F1.

[Synthesis Example 7]

In the same manner as in Synthesis Example 4 except that 85.9 g of PPVE, 4.27 g of methanol and 1.28 g of AIBN were used to obtain fluorinated polymer.
The composition of the obtained fluorinated polymer was PPVE units:TFE units=10:90 (mol%).
Then, under the same conditions as in Synthesis Example 3, the terminal group of the fluorinated polymer was replaced with a $-CF_3$ group to obtain fluorinated polymer G.
In the same manner as in Synthesis Example 3, the fluorinated polymer G was sublimated. Substances precipitated in the collecting portions at set temperatures of 250°C, 280°C and 310°C were collected to obtain 6 g of recovered fluorinated polymer G1.

[Synthesis Example 8]

In the same manner as in Synthesis Example 4 except that 152.9 g of PPVE, 2.40 g of methanol, 1.15 g of AIBN and 56.3 g of TFE were used to obtain fluorinated polymer.
The composition of the obtained fluorinated polymer was PPVE units:TFE units=14:86 (mol%).
Then, the obtained fluorinated polymer was heated in an oven at 330°C, then dipped in methanol and heated in an oven at 75°C for 40 hours to replace the terminal group with a methyl ester group to obtain fluorinated polymer H.
In the same manner as in Synthesis Example 1, the fluorinated polymer H was sublimated to obtain 4 g of purified fluorinated polymer H1.

[Synthesis Example 9]

30 g of perfluoro(3-butenyl vinyl ether), 30 g of AC2000 (manufactured by AGC Inc.), 0.5 g of methanol and 0.44 g of diisopropyl peroxydicarbonate (IPP) were weighed and put in a glass reactor having an internal capacity of 50 ml. The interior of the reactor was replaced with high purity nitrogen gas, and the reactor was heated to 40°C and polymerization was conducted for 24 hours.
The obtained solution was desolvated under 666 Pa (absolute pressure) at 50°C to obtain 28 g of polymer.
Then, the obtained polymer was heated in an oven at 300°C, then dipped in methanol and heated in an oven at 75°C for 20 hours to replace the terminal group with a methyl ester group to obtain fluorinated polymer I.
In the same manner as in Synthesis Example 4, the fluorinated polymer I was sublimated to obtain 4 g purified fluorinated polymer 11.

[Synthesis Example 10]

A jacketed polymerization vessel (made of stainless steel) having an internal capacity of 1.351 L was deaerated, and into the polymerization vessel, 331 g of R113 (1,1,2-trichloro-1,2,2-trifluoroethane, manufactured by AGC Inc.), 1.1 g of methanol and 765 g of hexafluoropropene (HFP) were put. Further, into the polymerization vessel, TFE was charged so that the pressure would be 1.34 MPaG at a temperature of 50°C.
Then, 54.7 ml of a 1.5 mass% solution (solvent: R113) of bis(perfluorobutyryl) peroxide was put to initiate the polymerization.
Since the pressure in the polymerization vessel decreased as the polymerization proceeded, TFE was continuously supplied so that the polymerization pressure would be substantially constant. The polymerization pressure was kept at 1.34 MPaG.
Into the polymerization vessel, a 1.5 mass% solution (solvent: R113) of bis(perfluorobutyryl) peroxide was intermittently put, and at a point when 86 g of TFE was consumed, the polymerization was terminated to obtain fluorinated copolymer J. The amount of TFE consumed was determined from the mass reduction of the TFE gas cylinder.
The composition of the obtained fluorinated polymer J was HFP units:TFE units=8:92 (mol%).
In the same manner as in Synthesis Example 4, the fluorinated polymer J was sublimated to obtain 4 g of purified fluorinated polymer J1.
Further, as a commercial fluorinated polymer, the following material was used which is a copolymer (PFA) of TFE and a perfluoroalkyl vinyl ether.

Fluon PFA: manufactured by AGC Inc., Fluon PFA P-63

Of the synthesized fluorinated polymers, physical properties were measured by the above methods. The physical properties measured are shown in Table 1.

[Table 1]

| | Melting point (°C) | 100% thermogravimetric loss temperature (°C) | Temperature width from 10% thermogravimetric loss temperature to 90% thermogravimetric loss temperature (°C) | Storage elastic modulus G' (Pa, at 25°C) | G' threshold temperature (°C) |
|---|---|---|---|---|---|
| A1 | 288 | 320 | 32 | $1\times10^{7}$ Pa or hiqher | 262 |
| B1 | 267 | 280 | 25 | $1\times10^{7}$ Pa or hiqher | 227 |
| B2 | 272 | 390 | 95 | $1\times10^{7}$ Pa or higher | 230 |
| C1 | 270 | 339 | 48 | $1\times10^{7}$ Pa or higher | 225 |
| D1 | 262 | 326 | 45 | $1\times10^{7}$ Pa or higher | 216 |
| E1 | 238 | 279 | 28 | $1\times10^{7}$ Pa or higher | 210 |
| F1 | 230 | 315 | 30 | $1\times10^{7}$ Pa or higher | 210 |
| G1 | 220 | 360 | 78 | $1\times10^{7}$ Pa or higher | 190 |
| J1 | 240 | 321 | 50 | $1\times10^{7}$ Pa or higher | 210 |
| H1 | 170 | 327 | 34 | $1\times10^{7}$ Pa or higher | 100 |
| B | 272 | 500< | 151 | $1\times10^{7}$ Pa or higher | 240 |
| H | 179 | 480 | 135 | $1\times10^{7}$ Pa or higher | 103 |
| I1 | Undetected | 325 | 45 | - | - |
| Fluon PFA | 308 | 500< | Measurement impossible | $1\times10^{7}$ Pa or higher | 280 |

It is found from Table 1 that the fluororesins A1 to G1 and J1 satisfy the requirements (1) to (3) according to the above embodiments, whereas the fluorinated polymers B and H and Fluon PFA do not satisfy the requirement (2) and (3) and the fluorinated polymers I1, H1 and H do not satisfy the requirement (1). The fluorinated polymer I1 is non-crystalline and has no crystallinity, and thus no boiling point was detected.

The fluorinated polymers shown in Table 1 were subjected to the following evaluations 1 to 5.

<Evaluation 1: chamber pressure change at the time of deposition>

[Method of evaluating chamber pressure change at the time of deposition]

0.1 g of the fluorinated polymer was put in a vacuum deposition apparatus, the pressure in the chamber was reduced to $10^{-4}$ Pa or lower, and the fluorinated polymer was deposited in a thickness of 200 nm at a deposition rate of

0.1 nm/sec. On that occasion, the pressure in the chamber was monitored, and the maximum value of the pressure at the time of deposition was measured. The pressure increase ratio was determined from the measured value in accordance with the following formula.

Chamber pressure increase ratio at the time of deposition= maximum pressure during deposition/initial pressure before deposition

A fluorinated polymer with the chamber pressure increase ratio of two times or less was evaluated as "favorable" and a fluorinated polymer with the ratio of higher than 2 times was evaluated as "poor".

<Evaluation 2: refractive index>

[Preparation of refractive index measurement sample]

On a silicon substrate, α-NPD as an organic semiconductor and the fluorinated polymer were co-deposited to form a 100 nm co-deposited film to obtain a refractive index measurement sample. The total deposition rate of the two materials was 0.2 nm/sec. The deposition rate was adjusted to achieve a desired volume ratio of α-NPD and the fluorinated polymer in the co-deposited film.

[Measurement of refractive index]

Using a multi incident angle spectroscopic ellipsometer (manufactured by J.A. Woollam, M-2000U), measurement was conducted at intervals of the angle of incidence of 5 degrees within a range of from 45 to 75 degrees, with respect to the film on the silicon substrate. At each angle, Ψ and Δ which are ellipsometry parameters were measured at intervals of about 1.6 nm within a wavelength range of from 450 to 800 nm. From the measurement data, the dielectric function of the organic semiconductor was subjected to fitting analysis by Cauchy's equation, and the refractive index of the deposited film to light having a wavelength of 600 nm was obtained.

<Evaluation 3: haze>

[Preparation of haze measurement sample]

On a glass substrate, α-NPD and the fluorinated polymer were co-deposited to form a 100 nm co-deposited film to obtain a haze measurement sample. The total deposition rate of the two materials was 0.2 nm/sec. The deposition rate was adjusted to achieve a desired volume ratio of α-NPD and the fluorinated polymer in the co-deposited film.

[Measurement of haze]

The haze was measured by using a haze meter (manufactured by Toyo Seiki Seisaku-sho, Ltd, Haze Guard K50-290).

The initial haze of the haze measurement sample was measured, then the sample was heated on a hot plate heated to 100°C for 1 hour. The sample was returned to room temperature, and the haze was measured again. Further, the sample was heated on a hot plate heated to 120°C for 1 hour, and the haze was measured in the same manner.

The obtained haze was evaluated based on the following standards.

○: less than 0.2,
△: 0.2 or more and less than 0.5
×: 0.5 or more

<Evaluation 4: heat resistance 1>

[Preparation of electrical conductivity evaluation element 1]

A glass substrate having ITO (indium tin oxide) formed in a 2 mm-width strip was used.

The substate was subjected to ultrasonic cleaning in neutral detergent, acetone and isopropanol, cleaned in boiling isopropanol, and subjected to ozone treatment to remove attachment on the surface of the ITO film.

The cleaned substrate was put in a vacuum deposition apparatus, the pressure was reduced to $10^{-4}$ Pa or lower, and molybdenum trioxide was deposited on the substrate. The deposition rate was 0.1 nm/sec, and a 5 nm-thick layer was formed to prepare a hole injection layer.

Then, on the hole injection layer, α-NPD and the fluorinated polymer were co-deposited. The total deposition

rate of the two materials was 0.2 nm/sec, and a 100 nm-thick layer was formed to prepare a charge transport layer. The deposition rate was adjusted to achieve a desired volume ratio of α-NPD and the fluorinated polymer in the charge transport layer.

Then, on the charge transport layer, aluminum was deposited in a 2 mm-width strip. The strip aluminum film was formed to be orthogonal to the ITO film in a field viewed from the direction perpendicular to the substrate. In such a manner, electrical conductivity evaluation element 1 having an element area of 4 $mm^2$ (=ITO film 2 mm × aluminum film 2 mm) was obtained.

[Evaluation of heat resistance of element 1]

Using a source meter (manufactured by Agilent Technologies, Inc., B1500A), a voltage was applied to the element 1 taking ITO as the anode and aluminum as the cathode while changing the voltage, a current flowing in the element was measured at each voltage, and the current density (J) (unit: $mA/cm^2$) to the electrical field (E) (unit: MV/cm) was obtained.

Then, in $N_2$ atmosphere, the element 1 was heated on a hot plate at 80°C for 60 minutes. The element 1 was returned to room temperature, and the current flowing in the element was measured again, and the current density (J) (unit: $mA/cm^2$) to the electrical field (E) (unit: MV/cm) was obtained.

Then, in $N_2$ atmosphere, the element 1 was heated on a hot plate at 90°C for 60 minutes. The element 1 was returned to room temperature, and the current flowing in the element was measured again, and the current density (J) (unit: $mA/cm^2$) to the electrical field (E) (unit: MV/cm) was obtained.

From the obtained results, the heat resistance of the element 1 was evaluated based on the following standards.

×: current density at 0.4 MV/cm was less than 90% of the initial value after heating to 80°C
△: current density at 0.4 MV/cm was less than 90% of the initial value after heating to 90°C
○: current density at 0.4 MV/cm was 90% or more of the initial value after heating to 90°C

<Evaluation 5: heat resistance 2>

[Preparation of electrical conductivity evaluation element 2]

Electrical conductivity evaluation element 2 was prepared in the same manner as in [Preparation of electrical conductivity evaluation element 1] except that HAT-CN was used instead of molybdenum trioxide, and HT211 was used instead of α-NPD.

[Evaluation of heat resistance of element 2]

In the same manner as in [Evaluation of heat resistance of element 1] except that the heating temperatures were 100°C, 110°C, 120°C and 130°C and the heating times were respectively 15 minutes, the current density (J) (unit: $mA/cm^2$) to the electric field (E) (unit: MV/cm) was obtained.

From the obtained results, the heat resistance of the element 2 was evaluated based on the following standards.

× : current density at 0.4 MV/cm was less than 90% of the initial value after heating to 100°C
△: current density at 0.4 MV/cm was less than 90% of the initial value after heating to 110°C
○: current density at 0.4 MV/cm was less than 90% of the initial value after heating to 120°C
○○: current density at 0.4 MV/cm was less than 90% of the initial value after heating to 130°C
○○○: current density at 0.4 MV/cm was 90% or more of the initial value after heating to 130°C

In the following Ex. 1 to 18, specific evaluations of the fluorinated polymers will be described.

[Ex. 1]

Using the fluorinated polymer A1, the above evaluations 1 to 3 and 5 were conducted.

In sample preparation in evaluations 2, 3 and 5, in co-deposition of the organic semiconductor and the fluorinated polymer, the deposition rate was adjusted so that the volume ratio of the organic semiconductor to the fluorinated polymer would be 50:50.

[Ex. 2]

Evaluations were conducted in the same manner as in Ex. 1 except that in sample preparation, the deposition rate was adjusted so that the volume ratio of the organic semiconductor to the fluorinated polymer would be 80:20.

[Ex. 3]

Evaluations were conducted in the same manner as in Ex. 1 except that in sample preparation the deposition rate was adjusted so that the volume ratio of the organic semiconductor to the fluorinated polymer would be 20:80.

[Ex. 4]

Using the fluorinated polymer B1, the above evaluations 1 to 5 were conducted.

In sample preparation in evaluations 2 to 5, in co-deposition of the organic semiconductor and the fluorinated polymer, the deposition rate was adjusted so that the volume ratio of the organic semiconductor to the fluorinated polymer would be 50:50.

[Ex. 5]

Evaluations were conducted in the same manner as in Ex. 1 except that the fluorinated polymer B2 was used.

[Ex. 6]

Evaluations were conducted in the same manner as in Ex. 1 except that the fluorinated polymer C1 was used.

[Ex. 7]

Evaluations were conducted in the same manner as in Ex. 4 except that the fluorinated polymer D1 was used.

[Ex. 8]

Evaluations were conducted in the same manner as in Ex. 1 except that the fluorinated polymer E1 was used.

[Ex. 9]

Evaluations were conducted in the same manner as in Ex. 1 except that the fluorinated polymer F1 was used.

[Ex. 10]

Evaluations were conducted in the same manner as in Ex. 1 except that the fluorinated polymer G1 was used.

[Ex. 11]

Evaluations were conducted in the same manner as in Ex. 1 except that the fluorinated polymer J1 was used.

[Ex. 12]

Evaluations were conducted in the same manner as in Ex. 1 except that the fluorinated polymer H1 was used.

[Ex. 13]

Evaluations were conducted in the same manner as in Ex. 1 except that the fluorinated polymer B was used.

[Ex. 14]

Evaluations were conducted in the same manner as in Ex. 1 except that the fluorinated polymer H was used.

[Ex. 15]

Evaluations 1 to 4 were conducted on the fluorinated polymer I1.

In sample preparation in evaluations 2 to 4, the deposition rate in the co-deposition of the organic semiconductor and the fluorinated polymer was adjusted so that the volume ratio of the organic semiconductor to the fluorinated polymer would be 50:50.

[Ex. 16]

Using a commercial fluorinated polymer Fluon PFA, <Evaluation 1: chamber pressure change at the time of deposition> was conducted.

Since the chamber pressure increase at the time of deposition in Evaluation 1 was significant, other evaluations which require co-deposition were not conducted.

[Ex. 17]

As an example using no fluorinated polymer, using a sample having an α-NPD single layer formed at a deposition rate of 0.1 nm/sec, the above evaluations 2 to 4 were conducted.

[Ex. 18]

As an example using no fluorinated polymer, using a sample having a HT211 single layer formed at a deposition rate of 0.1 nm/sec, the above evaluation 5 was conducted.

Among Ex. 1 to 18, Ex. 1 to 11 are Examples of the present invention, and Ex. 12 to 18 are Comparative Examples. The results are shown in Table 2.

[Table 2]

| | Fluorinated polymer | Pressure increase ratio at the time of deposition | Refractive index | Haze | | | Heat resistance | |
|---|---|---|---|---|---|---|---|---|
| | | | | Initial | After heating to 100°C | After heating to 120°C | Element 1 | Element 2 |
| Ex. 1 | A1 | 1.2 | 1.5 | ○ | ○ | ○ | - | ○○○ |
| Ex. 2 | A1 | 1.2 | 1.7 | ○ | ○ | △ | - | ○○○ |
| Ex. 3 | A1 | 1.2 | 1.4 | ○ | ○ | ○ | - | ○○○ |
| Ex. 4 | B1 | 1.0 | 1.5 | ○ | ○ | ○ | ○ | ○○○ |
| Ex. 5 | B2 | 1.8 | 1.5 | ○ | ○ | ○ | - | ○○○ |
| Ex. 6 | C1 | 1.3 | 1.5 | ○ | ○ | ○ | - | ○○○ |
| Ex. 7 | D1 | 1.1 | 1.5 | ○ | ○ | ○ | ○ | ○○○ |
| Ex. 8 | E1 | 1.4 | 1.5 | ○ | ○ | ○ | - | ○ |
| Ex. 9 | F1 | 1.2 | 1.5 | ○ | ○ | △ | - | ○ |
| Ex. 10 | G1 | 1.5 | 1.5 | ○ | ○ | △ | - | △ |

(continued)

| | Fluorinated polymer | Pressure increase ratio at the time of deposition | Refractive index | Haze | | | Heat resistance | |
|---|---|---|---|---|---|---|---|---|
| | | | | Initial | After heating to 100°C | After heating to 120°C | Element 1 | Element 2 |
| Ex. 11 | J1 | 1.6 | 1.5 | ○ | ○ | ○ | - | ○○○ |
| Ex. 12 | H1 | 1.2 | 1.5 | ○ | ○ | × | × | × |
| Ex. 13 | B | 3 | 1.5 | ○ | ○ | ○ | - | ○ |
| Ex. 14 | H | 8 | 1.5 | ○ | ○ | × | - | × |
| Ex. 15 | I1 | 1.0 | 1.5 | ○ | △ | × | × | - |
| Ex. 16 | Fluon PFA | 45 | - | - | - | - | - | - |
| Ex. 17 | - | - | 1.8 | ○ | × | × | ○ | - |
| Ex. 18 | - | - | - | - | - | - | - | ○○○ |

As a result of evaluation, it was found that in Ex. 1 to 11, there was no chamber pressure increase at the time of deposition, and stable deposition was possible.

It was found that in Ex. 1 to 11, the haze increase was suppressed even when heated.

It was found that the elements 1 and 2 in Ex. 1 to 11 were excellent in heat resistance.

Whereas in Ex. 13, 14 and 16, a chamber pressure increase at the time of deposition was confirmed, and the deposition state might be unstable.

Further, it was found that in Ex. 12, 14, 15 and 17, the haze increased by heating. It is considered that in Ex. 17, α-NPD was melted by heating and then crystallization proceeded, and thus a scattering source was generated. It is considered that in Ex. 12, 14 and 15, the nanodomain structure of the co-deposited film was changed by heating, and a scattering source was generated in the interior of the co-deposited film.

Further, it was found that in Ex. 12, 14 and 15, the elements 1 and 2 had low heat resistance.

From the above results, the present invention was confirmed to be useful.

The entire disclosure of Japanese Patent Application No. 2020-030460 filed on February 26, 2020, including specification, Claims, drawings and summary is incorporated herein by reference in its entirety.

REFERENCE SYMBOLS

10: film, 50: substrate, 51,52: deposition source, 51a: organic semiconductor, 51b: (organic semiconductor) domain, 52a: fluorinated polymer, 52b: (fluorinated polymer) domain, 100, 200: organic EL element (organic photoelectronic element), 110, 210: substrate, 111: anode, 112: hole injection layer, 113: hole transport layer, 114: light emitting layer, 115: electron transport layer, 116: electron injection layer, 117, 217: cathode, 500: chamber

## Claims

**1.** A fluorinated polymer which satisfies the following requirements (1) to (3):

(1) the melting point is 200°C or higher,

(2) the thermogravimetric loss rate when the temperature is increased at a temperature-increasing rate of 2°C/min under a pressure of $1\times10^{-3}$ Pa, substantially reaches 100% at 400°C or lower,

(3) when the temperature is increased at a temperature-increasing rate of 2°C/min under a pressure of $1\times10^{-3}$ Pa, the temperature width from a temperature at which the thermogravimetric loss rate is 10% to a temperature at which it is 90%, is within 100°C.

**2.** The fluorinated polymer according to Claim 1, wherein the storage elastic modulus at 25°C is $1\times10^{7}$ Pa or higher, and a temperature at which the storage elastic modulus which changes when the temperature is decreased at a temperature-decreasing rate of 2°C/min becomes less than $1\times10^{6}$ Pa, is 120°C or higher.

**3.** The fluorinated polymer according to Claim 1 or 2, which has units derived from a fluoroolefin.

**4.** The fluorinated polymer according to Claim 3, which has at least units derived from tetrafluoroethylene.

**5.** The fluorinated polymer according to Claim 3 or 4, which has units derived from a perfluoroalkyl vinyl ether.

**6.** The fluorinated polymer according to Claim 5, wherein the perfluoroalkyl vinyl ether is perfluoropropyl vinyl ether.

**7.** A film containing the fluorinated polymer as defined in any one of Claims 1 to 6, and an organic semiconductor.

**8.** The film according to Claim 7, wherein the proportion of the fluorinated polymer to the total amount of the fluorinated polymer and the organic semiconductor is from 20 to 80 vol%.

**9.** The film according to Claim 7 or 8, which further contains a dopant.

**10.** The film according to any one of Claims 7 to 9, which is a co-deposited film of the fluorinated polymer and the organic semiconductor.

**11.** A method for producing a film, which comprises a step of co-depositing the fluorinated polymer as defined in any one of Claims 1 to 6, and an organic semiconductor.

**12.** The method for producing a film according to Claim 11, wherein in the co-deposition step, a dopant is further used.

**13.** An organic photoelectronic element, comprising the film as defined in any one of Claims 7 to 10.

**14.** The organic photoelectronic element according to Claim 13, which comprises

a substrate,
an anode provided on the substrate,
a cathode facing the anode,
an active layer disposed between the anode and the cathode,
a hole transport layer disposed between the active layer and the anode, and
a hole injection layer disposed between the hole transport layer and the anode,
wherein at least one of the hole transport layer and the hole injection layer is the above-described film.

**15.** The organic photoelectronic element according to Claim 13 or 14, which comprises

a substrate,
an anode provided on the substrate,
a cathode facing the anode,
an active layer disposed between the anode and the cathode,
an electron transport layer disposed between the active layer and the cathode, and
an electron injection layer disposed between the electron transport layer and the cathode,
wherein at least one of the electron transport layer and the electron injection layer is the above-described film.

Fig. 1

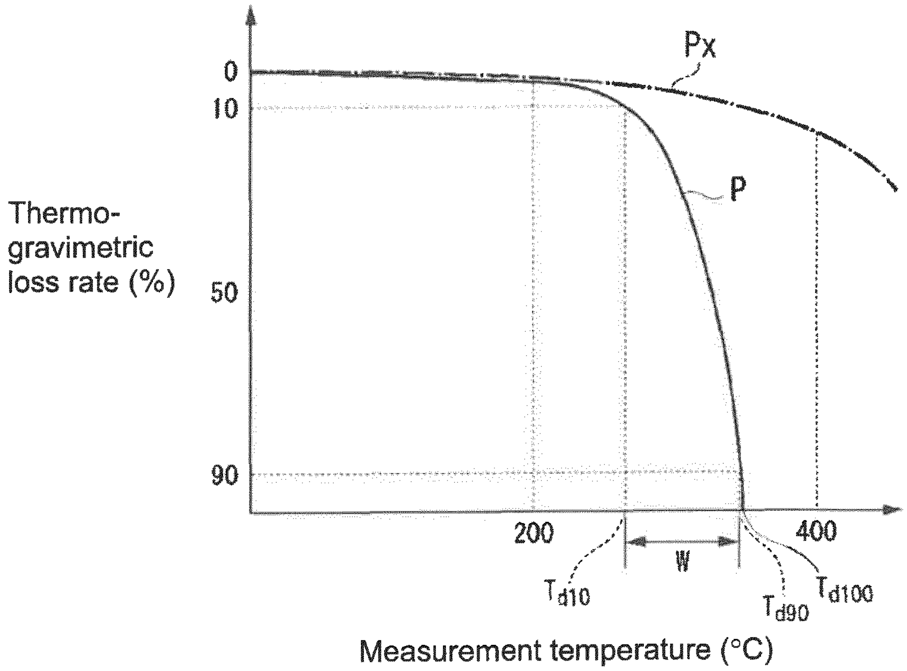


Fig. 2

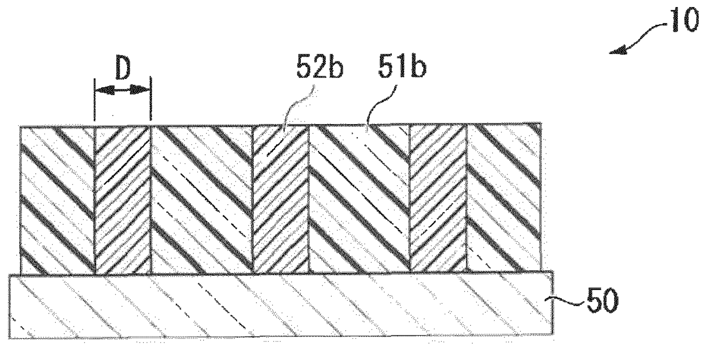


Fig. 3

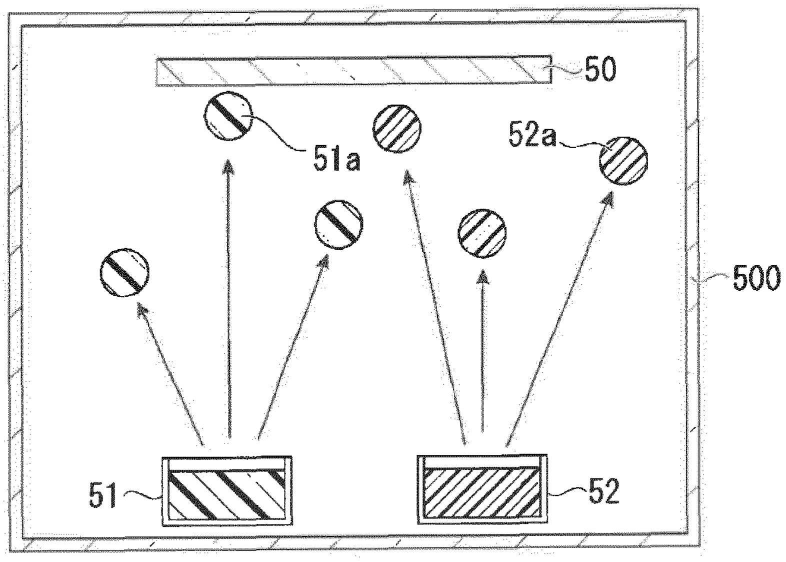

Fig. 4

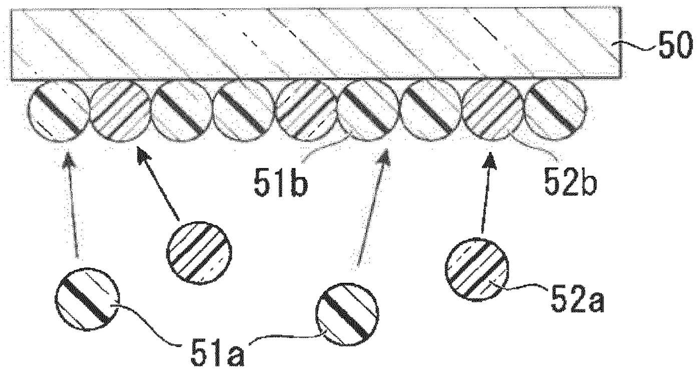


Fig. 5

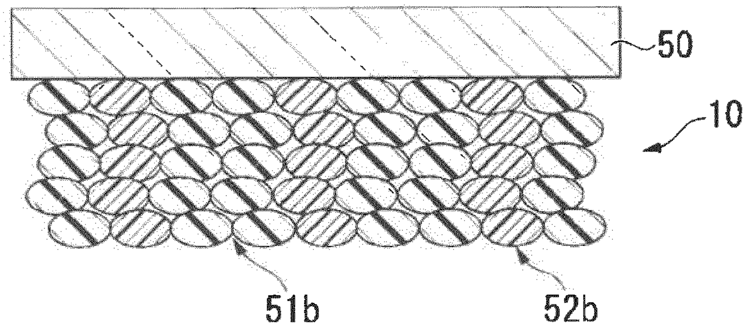


Fig. 6

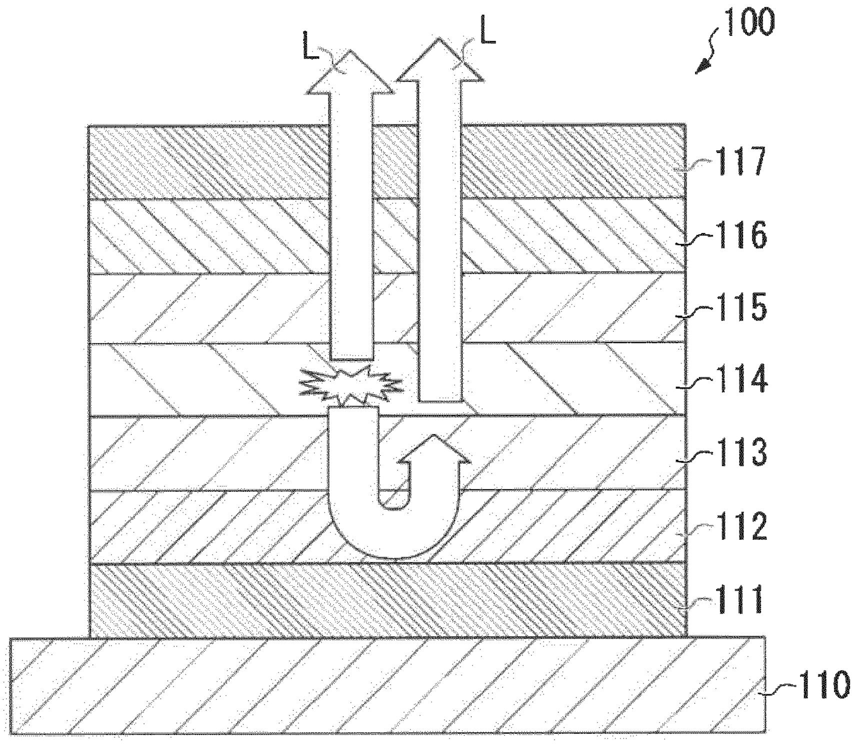

Fig. 7

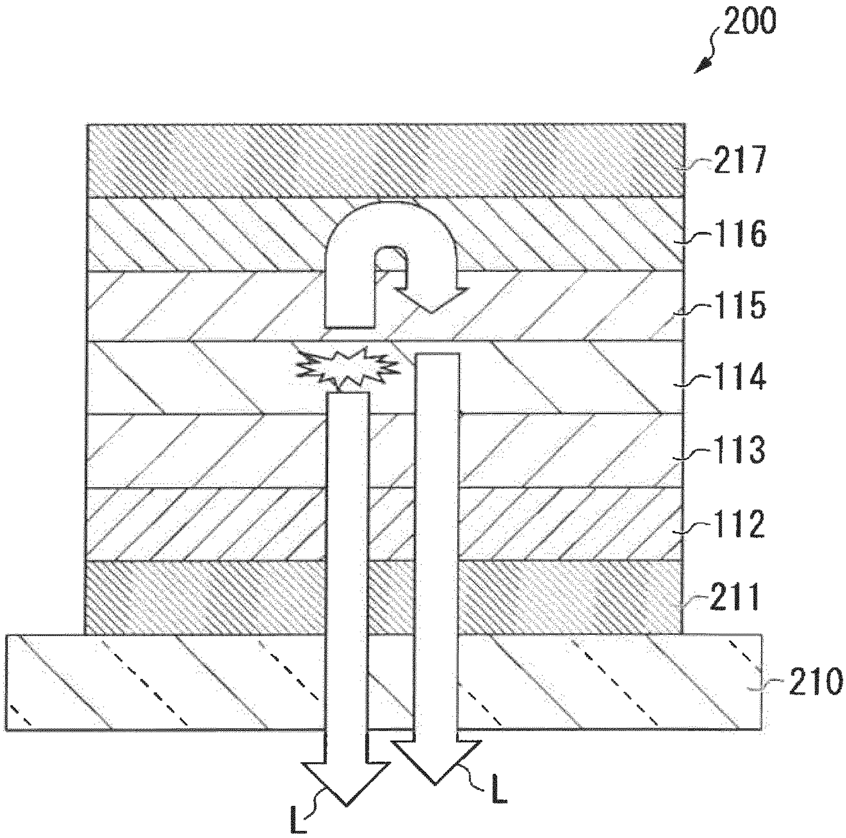

## INTERNATIONAL SEARCH REPORT

International application No.
PCT/JP2021/006902

A. CLASSIFICATION OF SUBJECT MATTER
C08F 14/18(2006.01)i; C08L 27/12(2006.01)i; H05B 33/10(2006.01)i; H01L 51/50(2006.01)i
FI: C08F14/18; C08L27/12; H05B33/14 A; H05B33/10; H05B33/22 D; H05B33/22 B
According to International Patent Classification (IPC) or to both national classification and IPC

B. FIELDS SEARCHED
Minimum documentation searched (classification system followed by classification symbols)
C08F14/18; C08L27/12; H05B33/10; H01L51/50

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2008/133088 A1 (ASAHI GLASS CO., LTD.) 06 November 2008 (2008-11-06) | 1-15 |
| A | JP 2018-126953 A (RICOH CO., LTD.) 16 August 2018 (2018-08-16) | 1-15 |
| A | JP 8-239242 A (CENTRAL GLASS CO., LTD.) 17 September 1996 (1990-09-17) | 1-15 |
| A | JP 9-25559 A (CENTRAL GLASS CO., LTD.) 28 January 1997 (1997-01-28) | 1-15 |
| A | JP 11-1593 A (SUMITOMO CHEMICAL INDUSTRY COMPANY LIMITED) 06 January 1999 (1999-01-06) | 1-15 |
| A | WO 2005/100420 A1 (DAIKIN INDUSTRIES, LTD.) 27 October 2005 (2005-10-27) | 1-15 |

☒ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
20 April 2021 (20.04.2021)

Date of mailing of the international search report
11 May 2021 (11.05.2021)

Name and mailing address of the ISA/
Japan Patent Office
3-4-3, Kasumigaseki, Chiyoda-ku,
Tokyo 100-8915, Japan

Authorized officer

Telephone No.

Form PCT/ISA/210 (second sheet) (January 2015)

**INTERNATIONAL SEARCH REPORT**

International application No.
PCT/JP2021/006902

C (Continuation). DOCUMENTS CONSIDERED TO BE RELEVANT

| Category* | Citation of document, with indication, where appropriate, of the relevant passages | Relevant to claim No. |
|---|---|---|
| A | WO 2009/096342 A1 (ASAHI GLASS CO., LTD.) 06 August 2009 (2009-08-06) | 1-15 |
| A | JP 2009-526351 A (E.I. DU PONT DE NEMOURS AND COMPANY) 16 July 2009 (2009-07-16) | 1-15 |
| A | JP 11-502243 A (THE UNIVERSITY OF NORTH CAROLINA AT CHAPEL HILL) 23 February 1999 (1999-02-23) | 1-15 |
| A | WO 2018/016644 A1 (ASAHI GLASS CO., LTD.) 25 January 2018 (2018-01-25) | 1-15 |

Form PCT/ISA/210 (continuation of second sheet) (January 2015)

**INTERNATIONAL SEARCH REPORT**
Information on patent family members

International application No. PCT/JP2021/006902

| Patent Documents referred in the Report | Publication Date | Patent Family | Publication Date |
|---|---|---|---|
| WO 2008/133088 A1 | 06 Nov. 2008 | US 2010/0080903 A1<br>EP 2143818 A1<br>CN 101663415 A<br>KR 10-2010-0014816 A<br>RU 2009142805 A<br>TW 200909597 A | |
| JP 2018-126953 A | 16 Aug. 2018 | (Family: none) | |
| JP 8-239242 A | 17 Sep. 1996 | (Family: none) | |
| JP 9-25559 A | 28 Jan. 1997 | (Family: none) | |
| JP 11-1593 A | 06 Jan. 1999 | (Family: none) | |
| WO 2005/100420 A1 | 27 Oct. 2005 | US 2007/0219333 A1<br>EP 1741732 A1<br>KR 10-2007-0009691 A<br>CN 1942492 A<br>TW 200536865 A | |
| WO 2009/096342 A1 | 06 Aug. 2009 | US 2010/0240791 A1<br>EP 2239284 A1<br>CN 101925622 A<br>KR 10-2010-0107446 A<br>TW 200940572 A | |
| JP 2009-526351 A | 16 Jul. 2009 | US 2008/0003449 A1<br>WO 2007/092296 A2<br>KR 10-2008-0103062 A<br>CN 101379162 A<br>TW 200740604 A<br>EP 2387041 A1<br>EP 2387042 A1 | |
| JP 11-502243 A | 23 Feb. 1999 | US 5981673 A<br>WO 1996/028477 A1<br>EP 813548 A1<br>CN 1181087 A<br>CN 1448413 A | |
| WO 2018/016644 A1 | 25 Jan. 2018 | US 2019/0144700 A1<br>EP 3489299 A1<br>CN 109476897 A<br>KR 10-2019-0034526 A<br>TW 201821517 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- CN 100557852
- JP H11152310 A
- JP 2020030460 A